(19) Europäisches Patentamt
European Patent Office
Office européen des brevets

(11) **EP 4 492 574 A1**

(12) **EUROPEAN PATENT APPLICATION**
published in accordance with Art. 153(4) EPC

(43) Date of publication:
**15.01.2025 Bulletin 2025/03**

(21) Application number: 23788384.8

(22) Date of filing: **13.04.2023**

(51) International Patent Classification (IPC):
**H01Q 3/30** (2006.01)    **G01N 21/17** (2006.01)
**H03B 7/08** (2006.01)

(52) Cooperative Patent Classification (CPC):
**G01N 21/17; H01Q 3/30; H01Q 21/06; H01Q 23/00;
H03B 7/08**

(86) International application number:
**PCT/JP2023/014969**

(87) International publication number:
**WO 2023/199966 (19.10.2023 Gazette 2023/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.04.2022 JP 2022067823**

(71) Applicant: **CANON KABUSHIKI KAISHA**
**Tokyo 146-8501 (JP)**

(72) Inventors:
• **KITAZAWA, Yuki**
**Tokyo 146-8501 (JP)**

• **KOYAMA, Yasushi**
**Tokyo 146-8501 (JP)**
• **ITSUJI, Takeaki**
**Tokyo 146-8501 (JP)**
• **MURAO, Tatsuya**
**Tokyo 146-8501 (JP)**
• **YUKIMASA, Koji**
**Tokyo 146-8501 (JP)**
• **SATO, Takahiro**
**Tokyo 146-8501 (JP)**

(74) Representative: **WESER & Kollegen**
**Patentanwälte PartmbB**
**Radeckestraße 43**
**81245 München (DE)**

(54) **ANTENNA DEVICE, COMMUNICATION DEVICE, AND IMAGING SYSTEM**

(57)    An antenna apparatus for generating or detecting an electromagnetic wave, comprises a first active antenna including a first oscillator and a first antenna, a second active antenna including a second oscillator and a second antenna, a coupling wire configured to couple the first antenna and the second antenna, a first terminal configured to accept a signal for controlling a first oscillation frequency of the first oscillator before synchronization by the coupling wire, and a second terminal configured to accept a signal for controlling, independently of the first oscillation frequency, a second oscillation frequency of the second oscillator before synchronization by the coupling wire.

**F I G. 1**

**Description**

TECHNICAL FIELD

The present invention relates to an antenna apparatus that outputs or detects an electromagnetic wave.

BACKGROUND ART

As a current injection light source that generates an electromagnetic wave such as a terahertz wave, there is known an oscillator formed by integrating a resonator and an element having an electromagnetic wave gain with respect to a terahertz wave. Among these, an oscillator formed by integrating a Resonant Tunneling Diode (RTD) and an antenna is expected as an element that operates at room temperature in a frequency domain around 1 THz. PTL 1 discloses a terahertz-wave antenna array in which a plurality of active antennas each formed by integrating an RTD oscillator and an antenna are arranged on the same substrate. In the antenna array disclosed in PTL 1, coupling wires that mutually couple the plurality of active antennas are used to cause the plurality of active antennas to oscillate in the same phase in synchronism with each other.

CITATION LIST

PATENT LITERATURE

PTL 1: Japanese Patent Laid-Open No. 2014-200065

NON PATENT LITERATURE

NPL 1: Jpn. J. Appl. Phys., Vol. 47, No. 6 (2008), pp. 4375-4384
NPL 2: J. Appl. Phys., Vol. 103, 124514 (2008)

SUMMARY OF INVENTION

TECHNICAL PROBLEM

In the antenna array described in PTL 1, it is possible to synchronize the phases of the plurality of active antennas with each other but application of beamforming of directing a beam in an arbitrary direction by controlling the phase difference between the active antennas has not been examined.

SOLUTION TO PROBLEM

The present invention provides a technique of making it possible to apply beamforming in an antenna apparatus including a plurality of active antennas.
An antenna apparatus according to one aspect of the present invention is an antenna apparatus for generating or detecting an electromagnetic wave, comprising a first active antenna including a first oscillator and a first antenna, a second active antenna including a second oscillator and a second antenna, a coupling wire configured to couple the first antenna and the second antenna, a first terminal configured to accept a signal for controlling a first oscillation frequency of the first oscillator before synchronization by the coupling wire, and a second terminal configured to accept a signal for controlling, independently of the first oscillation frequency, a second oscillation frequency of the second oscillator before synchronization by the coupling wire.

ADVANTAGEOUS EFFECTS OF INVENTION

According to the present invention, it is possible to apply beamforming in an antenna apparatus including a plurality of active antennas.
Other features and advantages of the present invention will be apparent from the following description taken in conjunction with the accompanying drawings. Note that the same reference numerals denote the same or like components throughout the accompanying drawings.

BRIEF DESCRIPTION OF DRAWINGS

The accompanying drawings, which are incorporated in and constitute a part of the specification, illustrate embodiments of the invention and, together with the description, serve to explain principles of the invention.

Fig. 1 is a block diagram schematically showing the arrangement of an antenna apparatus;
Fig. 2 is a circuit diagram of an antenna array;
Fig. 3 is a schematic plan view showing an example of the arrangement of the antenna apparatus;
Fig. 4A is a sectional view of an element included in the antenna apparatus;
Fig. 4B is a sectional view of the element included in the antenna apparatus;
Fig. 5A is a schematic view showing the effect of the antenna apparatus;
Fig. 5B is a schematic view for explaining beamforming;
Fig. 6 is a block diagram schematically showing the arrangement of an antenna apparatus;
Fig. 7 is a schematic plan view showing an example of the arrangement of the antenna apparatus;
Fig. 8 is a schematic plan view showing an element included in the antenna apparatus;
Fig. 9 is a schematic plan view showing an element included in an antenna apparatus;
Fig. 10A is a sectional view of the element included in the antenna apparatus;
Fig. 10B is a sectional view of the element included in the antenna apparatus;
Fig. 10C is a sectional view of the element included in the antenna apparatus;
Fig. 11 is a block diagram schematically showing the arrangement of an antenna apparatus;
Fig. 12 is a schematic plan view showing an example of the arrangement of the antenna apparatus;
Fig. 13A is a sectional view of an element included in the antenna apparatus;
Fig. 13B is a sectional view of the element included in the antenna apparatus;
Fig. 14A is a view showing an example of the arrangement of a camera system using an antenna apparatus; and
Fig. 14B is a view showing an example of the arrangement of a communication system using an antenna apparatus.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

[First Embodiment]

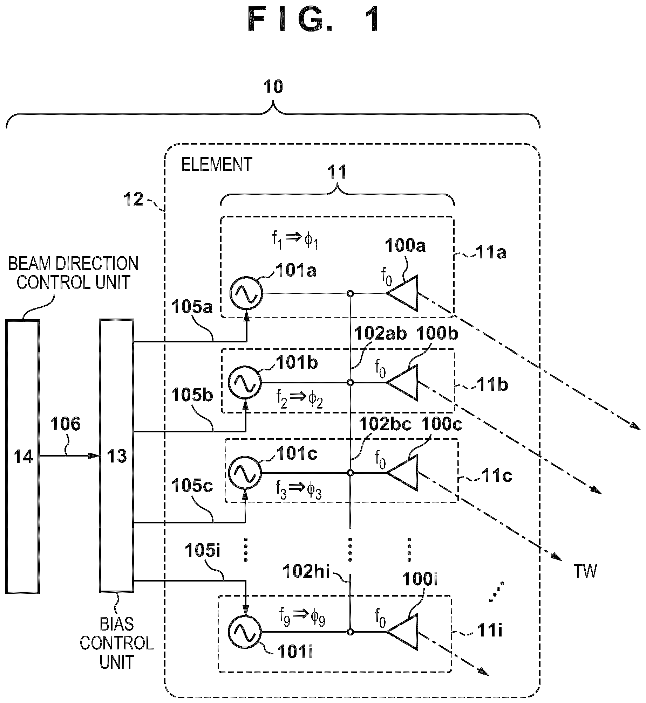

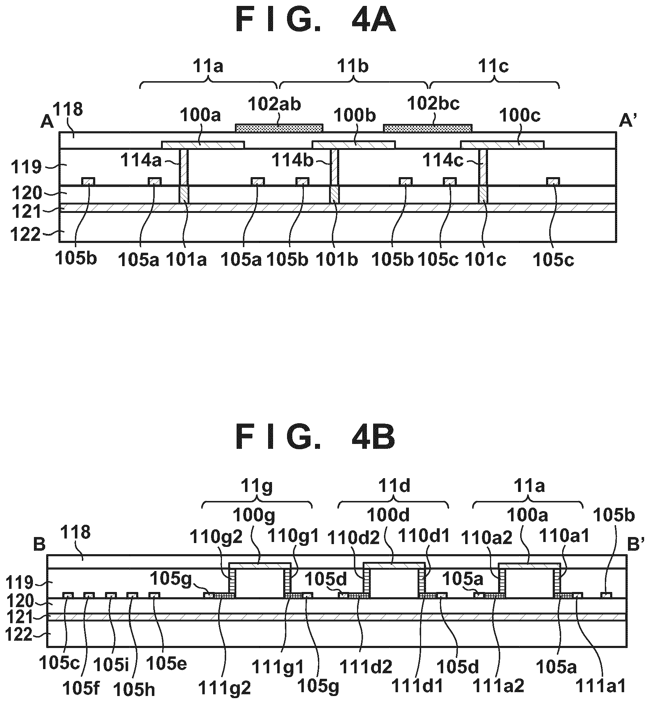

The arrangement of an antenna apparatus 10 applicable to a terahertz wave according to this embodiment will be described with reference to Figs. 1 to 4A and 4B. Note that a case where the antenna apparatus 10 is used as a transmitter will particularly be described below but the antenna apparatus 10 can also be used as a receiver. A terahertz wave indicates an electromagnetic wave within a frequency range of 10 GHz (inclusive) to 100 THz (inclusive), and indicates, in an example, an electromagnetic wave within a frequency range of 30 GHz (inclusive) to 30 THz (inclusive).

Fig. 1 is a block diagram for explaining an example of the system configuration of the antenna apparatus 10. The antenna apparatus 10 includes an element 12 in which antennas are formed, a bias control unit 13, and a beam direction control unit 14.

The element 12 is an antenna element including an antenna array 11 formed by arranging a plurality of active antennas 11a to 11i in an array. The active antenna 11a is formed by integrating at least one antenna 100a and a semiconductor 101a as an oscillation source, and is configured to emit a terahertz wave TW of an oscillation frequency $f_0$. The same applies to the remaining active antennas, and each active antenna includes an antenna and a semiconductor and is configured to emit the terahertz wave TW of the oscillation frequency $f_0$. In each of the active antennas 11a to 11i, components other than each of semiconductors 101a to 101i as an oscillation member may be interpreted as the antenna, and for example, only an antenna conductor or a combination of an antenna conductor and a ground (GND) conductor may be interpreted as the antenna. Note that the semiconductors 101a to 101i and the antennas 100a to 100i are formed in the same shape with respect to the active antennas 11a to 11i, respectively. Note that "same shape" indicates the same shape in designing, and also includes almost the same shape in an implemented article. Therefore, the semiconductors 101a to 101i and the antennas 100a to 100i have the same characteristic. Thus, if it is unnecessary to particularly discriminate these semiconductors and antennas, they will be referred to as the semiconductors 101 and the antennas 100 hereinafter. Each of the semiconductors 101a to 101i of the active antennas 11a to 11i includes a semiconductor structure for generating or detecting a terahertz wave. This embodiment will describe an example of using a Resonant Tunneling Diode (RTD) as the semiconductor structure. Note that as the semiconductor structure, a semiconductor having the nonlinearity of the carrier or the electromagnetic wave gain with respect to the terahertz wave (nonlinearity of a current along with a voltage change in the current-voltage characteristic) suffices, and the semiconductor structure is not limited to the RTD. Alternatively, an oscillator of an arbitrary form other than the semiconductor structure may be used. Note that the semiconductor for generating or detecting a terahertz wave will sometimes be referred to as the RTD hereinafter. The active antennas 11a to 11i are electrically connected by coupling wires 102ab to 102hi as transmission lines that mutually couple the antennas to cause a mutual injection locking phenomenon. For example, the active antennas 11a and 11b are connected by the coupling wire 102ab.

The bias control unit 13 is a power supply for controlling a bias signal to be applied to the semiconductor 101, and is electrically connected to the semiconductor 101 in the element 12 via a bias line 105. The beam direction control unit 14 supplies a control signal to the bias control unit 13 via a control line 106. The beam direction control unit 14 decides a bias voltage or current to be applied to each of the semiconductors 101a to 101i of the active antennas 11a to 11i by supplying the control signal to the bias control unit 13 via the control line 106. At least one of the bias voltage and the bias current will sometimes be referred to as a "bias" hereinafter. Each of the semiconductors 101a to 101i has a characteristic that the oscillation frequency changes depending on the bias applied to the semiconductor.

The active antennas 11a to 11i oscillate at different frequencies $f_1$ to $f_9$ in a terahertz band in accordance with the applied bias voltages, respectively. By the coupling wires 102ab to 102hi connected between the active antennas 11a to 11i, the active antennas 11a to 11i oscillate at the one frequency $f_0$ by a mutual injection locking phenomenon. The active antennas 11a to 11i oscillate at phases calculated from frequency differences between the frequency $f_0$ and the oscillation frequencies $f_1$ to $f_9$ without mutual injection locking, respectively. That is, the active antennas 11a to 11i oscillate with phase differences corresponding to the same frequency $f_0$ and the original oscillation frequencies $f_1$ to $f_9$, respectively.

In this embodiment, by focusing on the characteristic, the phase differences among the active antennas 11a to 11i are adjusted by adjusting the bias applied to each of the active antennas 11a to 11i. By adjusting the phase differences, beamforming can be performed to direct a beam in a predetermined direction from a substrate vertical direction (to direct the peak of the gain of the beam in the predetermined direction). In this embodiment, the beam direction control unit 14 decides the phase differences among the active antennas 11a to 11i, and supplies the control signal to the bias control unit 13 to supply the bias corresponding to each phase difference to each of the active antennas 11a to 11i. The bias control unit 13 applies the bias corresponding to the control signal to each of the active antennas 11a to 11i, thereby performing beamforming to direct the beam in the predetermined direction. This allows the antenna array 11 to emit the terahertz wave TW of the oscillation frequency $f_0$ to direct the peak of the antenna gain at an arbitrary angle from the substrate vertical direction.

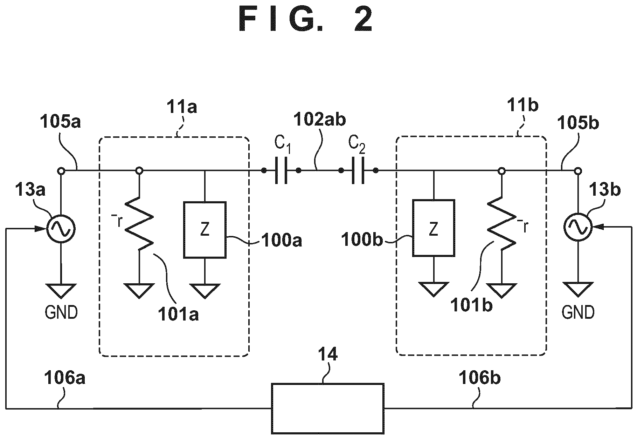

Fig. 2 is a circuit diagram for explaining electrical connection between the active antennas 11a and 11b. Note that a description will be provided by focusing on the relationship between the active antennas 11a and 11b but the same applies to the relationships among the remaining active antennas. In the active antenna 11a, a negative resistance -r of the semiconductor 101a and an impedance Z of the antenna 100a are connected in parallel. Note that the impedance Z includes a resistance component and an LC component caused by the structure of the antenna 100a. The bias applied by the bias control unit 13 to apply the bias current to the semiconductor 101a is represented as a power supply 13a. Note that the active antenna 11b also has the same arrangement. For example, the bias control unit 13 supplies a current necessary to drive the semiconductors 101a and 101b, and individually adjusts the biases applied to the semiconductors 101a and 101b. That is, the antenna apparatus 10 is configured to individually set the first bias applied to the semiconductor 101a and the bias applied to the semiconductor 101b. These biases are controlled when the beam direction control unit 14 supplies the control signal to the bias control unit 13 via control lines 106a and 106b, respectively. Note that Fig. 2 shows an arrangement example in which the beam direction control unit 14 transmits, to the bias control unit 13, the control signal via the signal line different for each active antenna, but the present invention is not limited to this. That is, as long as the bias control unit 13 is notified of information capable of specifying the bias to be applied to the semiconductor 101 of each active antenna, the bias control unit 13 may be notified of the information as one piece of information. On the other hand, the bias control unit 13 is configured to individually control the bias for each active antenna. The element 12 has a terminal (input line) for accepting a signal for individually controlling the magnitude of the bias for each active antenna. Note that in a case where the RTD is used as the semiconductor 101, the bias voltage is selected from voltages in a differential negative-resistance region of the RTD.

The adjacent active antennas 11a and 11b are electrically connected by the coupling wire 102ab, thereby mutually coupling the antennas. The coupling wire 102ab is connected to the active antennas 11a and 11b via capacitors $C_1$ and $C_2$. The capacitors $C_1$ and $C_2$ function as high-pass filters, and are set to be capacitors configured to be short-circuited with respect to an electromagnetic wave in the terahertz band and to be open with respect to an electromagnetic wave in a low-frequency band. Note that the remaining active antennas 11b to 11i have the same arrangement. Note also that an arrangement in which neither of the capacitors C1 and C2 is provided may be adopted.

(Implementation Example)

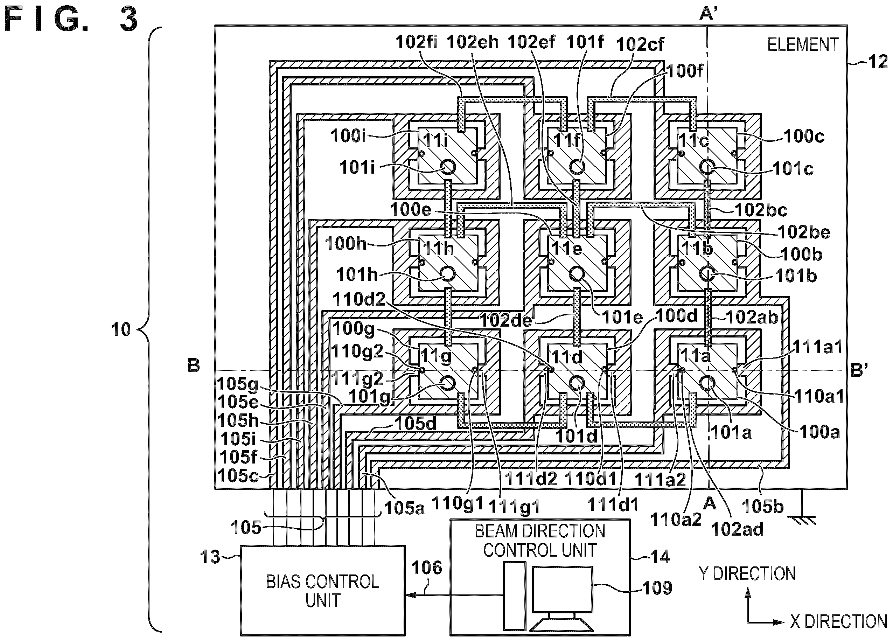

The structure and arrangement of the antenna apparatus 10 of the first embodiment will be described in detail with reference to Figs. 3, 4A, and 4B. Fig. 3 is a schematic plan view of the element 12 in which the nine active antennas 11a to 11i are arranged in a $3\times3$ matrix. Figs. 4A and 4B are sectional views of the element 12 taken along lines A - A' and B - B' in Fig. 3, respectively. The element 12 can be called, for example, a chip. The element 12 is an element that oscillates or detects the terahertz wave of the frequency $f_0$, and is made of a semiconductor material. In this embodiment, as the element 12, an antenna array in which the nine active antennas 11a to 11i are arranged in a $3\times3$ matrix will be exemplified. Note that in the example shown in Fig. 3, a square patch antenna is used as the antenna 100 included in each active antenna. However, the present invention is not limited to this. For example, the number of active antennas is not limited to nine, and even if the active antennas are arranged in a matrix, they may be arranged in a form other than the $3\times3$ matrix. That is, for arbitrary positive integers m and n, the active antennas 11a to 11i can be arranged in an $m\times n$ matrix (m or n is 2 or more), thereby forming the antenna array 11. When the number (that is, m or n) of active antennas increases, it is possible to improve the gain of the beam in the direction in which the beam is directed by narrowing the beam width. Note that when m or n is 1, the antenna array 11 has one column, and can perform beamforming in the arrangement direction. The antenna 100 may be, for example, a slot antenna, and need not be the patch antenna. Note that each of the active antennas 11a to 11i serves as a resonator that causes the terahertz wave to resonate and a radiator that transmits or receives the terahertz wave. In the element 12, the active antennas (antennas 100) can be arranged at a pitch (interval) equal to or smaller than the wavelength of the detected or generated terahertz wave or a pitch (interval) of an integer multiple of the wavelength. The discussion of this embodiment can also be applied not only to an antenna that emits a horizontally/vertically polarized wave but also to an antenna that emits a circularly polarized wave.

Each active antenna includes the semiconductor 101 as an oscillator, as described above, and the antennas arranged adjacent to each other are coupled by the coupling wire 102 to synchronize the oscillators with each other. The active antenna and each coupling wire 102 are connected by capacitive coupling. The length of the coupling wire 102 is designed to satisfy a phase matching condition in one or both of the X direction and the Y direction when the adjacent antennas are connected by the coupling wire. The coupling wire 102 can be designed to have, for example, such length that the electrical length in the coupling wire 102 between the semiconductors 101 of the adjacent active antennas is equal to an integer multiple of $2\pi$. That is, the length of the coupling wire 102 can be set so that the length of a path via the coupling wire 102 when the RTDs are connected by the coupling wire 102 is equal to an integer multiple of the wavelength of a propagated electromagnetic wave.

The arrangement of each active antenna forming the element 12 will be described first, and then the arrangement of the bias control unit 13 and the beam direction control unit 14 will be described. Then, after a description of examples of practical materials and structure dimensions, a manufacturing method of the element 12 will be explained. Note that the respective active antennas 11a to 11i have the same arrangement. Therefore, if it is unnecessary to particularly discriminate the active antennas 11a to 11i, they will collectively be referred to as the "active antennas" hereinafter. That is, the arrangement of the "active antenna" to be described below is applied to each of the active antennas 11a to 11i. Similarly, a symbol "a" is added to a member corresponding to the active antenna 11a but the symbol is omitted when it is unnecessary to particularly discriminate the active antennas.

(Active Antenna)

As shown in Figs. 4A and 4B, the active antenna includes a substrate 122, a conductor layer 121, a conductor (to be sometimes referred to as the "conductor 100" hereinafter) forming the antenna 100, and dielectric layers 119 and 120. Note that as shown in Figs. 4A and 4B, the substrate 122, the conductor layer 121, and the conductor 100 are stacked in this order, and the dielectric layers 119 and 120 are located between two conductor layers (wiring layers) of the conductor layer 121 and the conductor 100. Note that the dielectric layers 119 and 120 are arranged in the order of the dielectric layer 120 and the dielectric layer 119 from the side of the conductor layer 121. The arrangement of the antenna shown in Figs. 4A and 4B is called a microstrip antenna using a microstrip line having an finite length. An example of using a patch antenna as a microstrip resonator will now be described. The conductor 100 is the patch conductor of the active antenna (the upper conductor of the patch antenna) arranged to face the conductor layer 121 via the dielectric layers 119 and 120. The conductor layer 121 serves as an electrically grounded ground conductor (GND conductor), and also serves as a reflector layer. The active antenna is set to operate as a resonator in which the width of the conductor 100 in the Y direction (resonant direction) in Fig. 3 is $\lambda_{THz}/2$. Note that $\lambda_{THz}$ represents an effective wavelength, in the dielectric layers 119 and 120, of the terahertz wave that resonates in the active antenna. If $\lambda_0$ represents the wavelength of the terahertz wave in a vacuum, and $\varepsilon_r$ represents the effective relative permittivity of the dielectric layer 119, $\lambda_{THz} = \lambda_0 \times \varepsilon_r^{-1/2}$ is obtained.

The active antenna has the semiconductor 101 (semiconductor layer or semiconductor structure). The semiconductor layer corresponds to each of the semiconductors 101a to 101i in Fig. 1, and is a Resonant Tunneling Diode (RTD) in this embodiment, as described above. The RTD is a typical semiconductor structure having an electromagnetic wave gain in the frequency band of the terahertz wave, and is also called an active layer. Therefore, the semiconductor 101 will sometimes be referred to as the "RTD" hereinafter. The RTD has a resonant tunneling structure layer including a plurality of tunneling barrier layers in which a quantum well layer is provided between the plurality of tunneling barrier layers, and has a multiquantum well structure for generating a terahertz wave by inter-subband carrier transition. The RTD has an electromagnetic wave gain in the frequency domain of the terahertz wave based on a photon-assisted tunneling phenomenon in the differential negative-resistance region of the current-voltage characteristic, and performs self-oscillation in the differential negative-resistance region.

The semiconductor 101 is electrically connected to the conductor 100. The semiconductor structure is, for example, a mesa structure, and the semiconductor 101 includes an electrode (for example, an ohmic or Schottky electrode) for contact with the semiconductor structure and an electrode layer for connection to the upper and lower wiring layers. The semiconductor 101 is located in the active antenna, and is configured to oscillate or detect the electromagnetic wave of the terahertz wave. The semiconductor 101 is formed from a semiconductor layer having nonlinearity or an electromagnetic wave gain with respect to the terahertz wave.

The active antenna is an active antenna formed by integrating the semiconductor 101 and the patch antenna (conductor 100). The frequency $f_{THz}$ of the terahertz wave oscillated from the single active antenna is decided based on the resonance frequency of a fully-parallel resonant circuit obtained by combining the patch antenna and the reactance of the semiconductor 101. More specifically, with respect to a resonant circuit obtained by combining the admittances (YRTD and Yaa) of an RTD and an antenna from the equivalent circuit of the oscillator described in NPL 1, a frequency satisfying an amplitude condition given by expression (1) and a phase condition given by equation (2) is decided as the oscillation frequency $f_{THz}$.

$$\mathrm{Re}[\mathrm{YRTD}] + \mathrm{Re}[\mathrm{Y}11] \leq 0 \qquad \qquad ...(1)$$

$$\mathrm{Im}[\mathrm{YRTD}] + \mathrm{Im}[\mathrm{Y}11] = 0 \qquad \qquad ...(2)$$

where YRTD represents the admittance of the semiconductor 101, Re represents a real part, and Im represents an imaginary part. Since the semiconductor 101 includes the RTD as a negative-resistance element, Re[YRTD] has a negative value. Y11 represents the admittance of the whole structure of the active antenna when viewed from the semiconductor 101.

Note that as the semiconductor 101, a Quantum Cascade Laser (QCL) having a semiconductor multilayer structure of several hundred to several thousand layers may be used. In this case, the semiconductor 101 is a semiconductor layer including the QCL structure. As the semiconductor 101, a negative-resistance element such as a Gunn diode or IMPATT diode often used in the millimeter wave band may be used. As the semiconductor 101, a high-frequency element such as a transistor with one terminal terminated may be used, and a heterojunction bipolar transistor (HBT), a compound semiconductor FET, a high electron mobility transistor (HEMT), or the like can be used as the transistor. As the semiconductor 101, a differential negative resistance of the Josephson device using a superconductor layer may be used. That is, the semiconductor 101 need not be the RTD as long as it has the semiconductor structure for generating or detecting an electromagnetic wave in a predetermined frequency band, and an arbitrary structure having the same characteristic may be used. In this example, the RTD is used as a component suitable for the terahertz wave, but an antenna array corresponding to an electromagnetic wave in an arbitrary frequency band may be implemented by an arrangement described in this embodiment. That is, the semiconductor 101 according to this embodiment is not limited to the RTD that outputs the terahertz wave, and can be formed using a semiconductor that can output an electromagnetic wave in an arbitrary frequency band.

If the microstrip resonator such as a patch antenna has a thick dielectric layer, a conductor loss is reduced and the radiation efficiency is improved. It is required for the dielectric layers 119 and 120 that a thick film can be formed (typically, 3 μm or more), a low loss/low dielectric constant is obtained in the terahertz band, and fine processability is high (planarization or etching). As the thickness of the dielectric layer is larger, the radiation efficiency is higher, but if the thickness is too large, multi-mode resonance may occur. Therefore, the thickness of the dielectric layer can be designed within a range whose upper limit is 1/10 of the oscillation wavelength. On the other hand, to implement the high frequency and high output of the oscillator, micronization and high current density of the diode need to be implemented. To do this, the dielectric layer is also required to suppress a leakage current and take measures against migration as the insulating structure of the diode. To satisfy the above two requirements, dielectric layers of different materials may be used as the dielectric layers 119 and 120.

As the material of the dielectric layer 119, an organic dielectric material such as BCB (benzocyclobutene of the Dow Chemical Company, $\varepsilon_{r1} = 2$), polytetrafluoroethylene, or polyimide can be used. In this example, $\varepsilon_{r1}$ represents the relative permittivity of the dielectric layer 119. A TEOS oxide film that can form a relatively thick film and has a low dielectric constant or an inorganic dielectric material such as spin-on-glass may be used for the dielectric layer 119. The dielectric layer 120 is required to have an insulation property (the property of behaving as an insulator or high resistor that does not conduct electricity with respect to a DC voltage), a barrier property (the property of preventing spread of a metal material used for an electrode), and processability (processibility with sub-micron accuracy). As a material satisfying these properties, for example, an inorganic insulator material such as silicon oxide ($\varepsilon_{r2} = 4$), silicon nitride ($\varepsilon_{r2} = 7$), aluminum oxide, or aluminum nitride is used. $\varepsilon_{r2}$ represents the relative permittivity of the dielectric layer 120. Note that a dielectric layer 118 can also have the same characteristic as that of the dielectric layer 120.

As in this embodiment, if the dielectric layers 119 and 120 have a multilayer arrangement, the relative permittivity $\varepsilon_r$ of the dielectric layers 119 and 120 is the effective relative permittivity decided based on the thickness and relative permittivity $\varepsilon_{r1}$ of the dielectric layer 119 and the thickness and relative permittivity $\varepsilon_{r2}$ of the dielectric layer 120. To decrease the difference in dielectric constant between the antenna and air from the viewpoint of impedance matching between the antenna and a space, a material different from that of the dielectric layer 120 and having a low relative permittivity ($\varepsilon_{r1} < \varepsilon_{r2}$) can be used for the dielectric layer 119. Note that in the antenna apparatus 10, the dielectric layer need not have a multilayer arrangement, and may have a structure formed by a layer of one of the above-described materials.

The semiconductor 101 is arranged on the conductor layer 121 formed on the substrate 122. The semiconductor 101 and the conductor layer 121 are electrically connected to each other. Note that to reduce an ohmic loss, the semiconductor 101 and the conductor layer 121 can be connected with low resistance. A via 114 is arranged on the opposite side of the side on which the conductor layer 121 is arranged with respect to the semiconductor 101, and is electrically connected to the semiconductor 101. The semiconductor 101 is embedded in the dielectric layer 120, and the dielectric layer 120 covers the periphery of the semiconductor 101. Note that "via" indicates a through electrode extending through the layers.

The semiconductor 101 includes an ohmic electrode as a conductor that makes ohmic contact to the semiconductor to reduce RC delay and an ohmic loss caused by series resistance. As the material of the ohmic electrode, for example, Ti/Au, Ti/Pd/Au, Ti/Pt/Au, AuGe/Ni/Au, TiW, Mo, ErAs, or the like can be used. Note that this material is represented by chemical symbols, and a material represented by each chemical symbol will not be described in detail. The same applies to the following description. By decreasing the contact resistance using a semiconductor in which a region where the semiconductor contacts the ohmic electrode is doped with impurities at a high concentration, high output and a high frequency can be implemented. In a case where the RTD is used as the semiconductor 101, the absolute value of the negative resistance indicating the magnitude of the gain of the RTD used in the terahertz wave band is on the order of about 1 to 100 $\Omega$, and thus a loss of an electromagnetic wave can be suppressed to 1% or less. Therefore, the contact resistance in the ohmic electrode can be suppressed to 1 $\Omega$ or less as a guide. To operate in the terahertz wave band, the semiconductor 101 is formed to have a width of about 0.1 to 5 $\mu$m as a typical value. Therefore, the contact resistance is suppressed within the range of 0.001 $\Omega$ to several $\Omega$ by setting the resistivity to 10 $\Omega \cdot \mu m^2$ or less.

The semiconductor 101 may be configured to include a metal (Schottky electrode) that makes not ohmic contact but Schottky contact. In this case, the contact interface between the Schottky electrode and the semiconductor exhibits a rectifying property, and the active antenna AA can be used as a terahertz wave detector. Note that an arrangement using an ohmic electrode will be described below.

As shown in Fig. 4A, the substrate 122, the conductor layer 121, the semiconductor 101, the via 114, the conductor 100, and the coupling wire 102 (conductor) are stacked in the active antenna in this order. The via 114 is a conductor formed in the dielectric layer 119, and the conductor 100 and the semiconductor 101 are electrically connected via the via 114. If the width of the via 114 is too large, the radiation efficiency deteriorates due to deterioration of the resonance characteristic of the patch antenna and an increase in parasitic capacitance. Therefore, the width of the via 114 can be set to a width that does not interfere with a resonance electric field, typically, to 1/10 or less of an effective wavelength $\lambda$ of the standing terahertz wave of the oscillation frequency $f_0$ in the active antenna. The width of the via 114 may be small to the extent that series resistance is not increased, and can be reduced to about twice a skin depth as a guide. Considering that the series resistance is decreased to a value not exceeding 1 $\Omega$, the width of the via 114 typically falls within the range of 0.1 $\mu$m (inclusive) to 20 $\mu$m (inclusive), as a guide.

Referring to Fig. 4B, the conductor 100 is electrically connected to a wiring 111 via a via 110, and the wiring 111 is electrically connected to the bias control unit 13 via the bias line 105 as a wiring formed in the chip. The bias line 105 is arranged between the conductor 100 and the conductor layer 121, and more specifically, at an intermediate point between the dielectric layers 119 and 120. Note that the bias line 105 is arranged at a position that does not overlap the conductor 100 in a planar view so as not to receive the influence of the radiation of the antenna or influence the radiation of the antenna. The two wirings 111 are extracted from each antenna. For example, referring to Figs. 3 and 4B, with respect to the conductor 100a of the active antenna 11a, vias 110a1 and 110a2 are extracted and connected to wirings 111a1 and 111a2, respectively. The wirings 111a1 and 111a2 are electrically connected to the bias control unit 13 via the bias line 105a. The bias control unit 13 is a power supply for supplying a bias signal to the semiconductor 101 of the active antenna. Therefore, if the bias line 105 is connected to the wiring 111 extracted from each antenna, the bias is supplied to the semiconductor 101 of each antenna. In this embodiment, when the bias line 105 is individually prepared for each active antenna, it is possible to individually set the bias to be applied to the semiconductor 101 in each active antenna. For example, the bias control unit 13 individually controls, via a terminal for individually controlling the bias for each of the plurality of active antennas provided in the element 12, the bias to be applied to the semiconductor 101 of each active antenna.

The via 110 is a connecting portion for electrically and mechanically connecting the wiring 111 to the conductor 100. A structure that electrically connects the upper and lower layers is called a via. In addition to the role as a member forming the patch antenna, the conductor layer 121 and the conductor 100 are connected to these vias to serve as an electrode for injecting a current into the RTD as the semiconductor 101. In this embodiment, as the via 110 and the wiring 111, a material having a resistivity of $1 \times 10\text{-}6\,\Omega\cdot\text{m}$ or less can be used. More specifically, as the material, a metal or a metal compound such as Ag, Au, Cu, W, Ni, Cr, Ti, Al, AuIn alloy, or TiN is used.

The width of the via 110 is smaller than that of the conductor 100. The width of the conductor 100 corresponds to the width in the electromagnetic wave resonance direction (that is, the Y direction in Fig. 3) in the active antenna. The width of a portion (connecting portion) of the wiring 111 connected to the via 110 is smaller (thinner) than that of the conductor 100 (active antenna). These widths can be 1/10 or less ($\lambda/10$ or less) of the effective wavelength $\lambda$ of the standing terahertz wave of the oscillation frequency $f_0$ in the active antenna. This is because if the via 110 and the wiring 111 are arranged at positions with widths such that they do not interfere with a resonance electric field in the active antenna, the radiation efficiency can be improved.

The position of the via 110 can be arranged at the node of the electric field of the standing terahertz wave of the oscillation frequency $f_0$ in the active antenna. At this time, the via 110 and the wiring 111 are configured so that the impedance is sufficiently higher than the absolute value of the differential negative resistance of the RTD as the semiconductor 101 in the frequency band around the oscillation frequency $f_0$. In other words, the via 110 and the wiring 111 are connected to another active antenna so as to obtain a high impedance when viewed from the RTD at the oscillation frequency $f_0$. In this case, the other active antenna is isolated (separated) in a path via the bias line 105 at the frequency $f_0$. Thus, a current of the oscillation frequency $f_0$ induced by each active antenna does not influence the adjacent antenna via the bias line 105 and the bias control unit 13. In addition, interference between the standing electric field of the oscillation frequency $f_0$ in the active antenna and these power supply members is suppressed.

The bias control unit 13 is arranged outside the chip to supply a bias signal to the semiconductor 101 of each antenna. The bias control unit 13 can include a stabilization circuit for suppressing a parasitic oscillation of a low frequency. The stabilization circuit is set to have an impedance lower than the absolute value of the negative resistance corresponding to the gain of the semiconductor 101 in a frequency band from DC to 10 GHz. To stabilize a relatively high frequency of 0.1 to 10 GHz, an AC short circuit can be arranged by series-connecting a resistance layer of TiW and a MIM (Metal-Insulator-Metal) capacitor to each of the bias lines 105a to 105i. In this case, the MIM capacitor has a large capacity within the above-described frequency range, and has a capacity of about several pF in an example.

(Antenna Array)

Fig. 3 shows the arrangement of the antenna array 11 in which the nine active antennas 11a to 11i are arranged in a $3\times3$ matrix, and each of these active antennas singly oscillates the terahertz wave of each of the frequencies $f_1$ to $f_9$. Note that the number of active antennas is not limited to nine. For example, 16 active antennas may be arranged in a $4\times4$ matrix, or 15 active antennas may be arranged in a $3\times5$ matrix. The adjacent antennas are mutually coupled by the coupling wire 102, and are synchronized with each other by a mutual injection locking phenomenon to output the terahertz wave of the oscillation frequency $f_0$. The mutual injection locking phenomenon is a phenomenon in which a plurality of self oscillators are pulled by interaction to oscillate in synchronism with each other. For example, the active antennas 11a and 11d are mutually coupled by the coupling wire 102ad, and are mutually coupled via the conductor layer 121. The same applies to other adjacent active antennas. Note that "mutually coupled" indicates such relationship that when a current induced by a given active antenna acts on another adjacent active antenna by the coupling, the transmission/reception characteristic of one another is changed. If the mutually coupled active antennas are synchronized with each other in the same phase or opposite phases, the mutual injection locking phenomenon causes electromagnetic fields to strengthen or weaken each other between the active antennas. This can adjust the increase/decrease of the gain of the antenna. Note that in this embodiment, to generally represent the coupling wire that couples the active antennas, it is described as the coupling wire 102. A coupling wire that forms the coupling wire 102 and couples the antennas is described using alphabets corresponding to the active antennas. For example, the coupling wire that couples the active antennas 11a and 11d is described as the coupling wire 102ad.

The oscillation condition of the antenna array 11 is decided by the condition of mutual injection locking in an arrangement in which two or more individual RTD oscillators are coupled, which is described in NPL 2. More specifically, consider the oscillation condition of the antenna array in which the active antennas 11a and 11b are coupled by the coupling wire 102ab. At this time, two oscillation modes of positive-phase mutual injection locking and negative-phase mutual injection locking occur. The oscillation condition of the oscillation mode (even mode) of positive-phase mutual injection locking is represented by expression (4) and equation (5), and the oscillation condition of the oscillation mode (odd mode) of negative-phase mutual injection locking is represented by expression (6) and equation (7).

positive phase (even mode): frequency f = feven

$$Yeven = Y11 + Y12 + YRTD$$

$$Re(Yeven) \leq 0 \qquad \qquad ...(4)$$

$$Im(Yeven) = 0 \qquad \qquad ...(5)$$

negative phase (odd mode): frequency f = fodd

$$Yodd = Y11 + Y12 - YRTD$$

$$Re(Yodd) \leq 0 \qquad \qquad ...(6)$$

$$Im(Yodd) = 0 \qquad \qquad ...(7)$$

where Y12 represents the mutual admittance between the active antennas 11a and 11b. Y12 is proportional to a coupling constant representing the strength of coupling between the antennas, and ideally, the real portion of -Y12 is large and the imaginary portion is zero. In the antenna array 11 of this embodiment, the active antennas are coupled under the condition of positive-phase mutual injection locking, and oscillation frequency $f_0 \approx$ feven is obtained. Similarly, with respect to the remaining antennas, the antennas are coupled by the coupling wire 102 to satisfy the above-described condition of positive-phase mutual injection locking.

The coupling wire 102 is a microstrip line obtained by sandwiching the dielectric layers 118 to 120 by the conductor of the coupling wire 102 and the conductor layer 121 or the bias line 105. For example, as shown in Fig. 4A, the coupling wire 102ab has a structure in which the dielectric layers 118 to 120 are sandwiched by the conductor of the coupling wire 102ab and the conductor layer 121 or the bias line 105. Similarly, a coupling wire 102bc has a structure in which the dielectric layers 118 to 120 are sandwiched by the conductor of the coupling wire 102bc and the conductor layer 121 or the bias line 105.

The antenna array 11 is an antenna array having an arrangement in which the antennas are coupled by AC coupling (capacitive coupling). For example, in a planar view, the upper conductor layer (102bc in Fig. 4A) of the coupling wire 102bc overlaps the conductor 100 as the patch conductor of each of the active antennas 11b and 11c by sandwiching the dielectric layer 118, and is connected to the conductor 100 by capacitive coupling. More specifically, in a planar view, the conductor of the coupling wire 102bc overlaps the conductor 100 by only 5 $\mu$m by sandwiching the dielectric layer 118 near the radiation end of each of the active antennas 11b and 11c, thereby forming each of capacitor structures $C_1$ and $C_2$. The capacitor structures $C_1$ and $C_2$ correspond to the capacitors $C_1$ and $C_2$ in the circuit diagram shown in Fig. 3. The capacitors $C_1$ and $C_2$ of this arrangement function as high-pass filters, and contribute to suppression of multi-mode oscillation by being short-circuited with respect to an electromagnetic wave in the terahertz band and being open with respect to an electromagnetic wave in the low frequency band. However, this arrangement is not an essential requirement, and an arrangement of DC coupling such that the conductor of the coupling wire 102bc and the conductors 100 of the active antennas 11b and 11c are directly coupled (directly connected) may be used. Since the antenna array synchronized by DC coupling can synchronize the adjacent antennas by strong coupling, the antenna array readily performs a pull-in synchronization operation. Note that coupling between the active antennas 11b and 11c has been exemplified, but the same applies to couplings among the remaining active antennas 11a to 11i.

In the antenna array 11, the conductor 100 of the active antenna, the conductor of the coupling wire 102, and the bias line 105 are arranged in different layers. In this way, the conductor 100 of the active antenna and the coupling wire 102 that transmit an electromagnetic wave of a high frequency (a frequency in the terahertz band) and the bias wiring layer that transmits an electromagnetic wave of a low frequency (DC to several ten GHz) can be arranged in different layers. This can freely set the width, the length, and the layout, such as routing, of the transmission line in each layer. As shown in Fig. 4A, the coupling wire 102 and the bias line 105 intersect each other when viewed from above (in a planar view), thereby obtaining a layout-saving arrangement. This can increase the number of antennas to be arranged even in an antenna array in which antennas are arranged in an m×n (m ≥ 2, n ≥ 2) matrix.

Note that since resistance by the skin effect increases in the terahertz band, a conductor loss along with high-frequency transmission between antennas is not negligible. Along with an increase in current density between conductor layers, a conductor loss (dB/mm) per unit length increases. In the case of a microstrip line, a conductor loss (dB/mm) per unit length is inversely proportional to the square of a dielectric thickness. Therefore, to increase the radiation efficiency of the antenna array, it is possible to reduce a conductor loss by increasing the thickness of the dielectric forming the coupling wire 102 in addition to the antenna. To the contrary, the antenna array 11 of this embodiment has an arrangement in which the bias line 105 is arranged in the dielectric layer 120, and the conductor 100 of the antenna and the conductor of the coupling wire 102 that transmit an electromagnetic wave of a high frequency such as a frequency in the terahertz band are arranged in the upper layer of the dielectric layer 119. This arrangement can suppress a decrease in radiation efficiency of the antenna array along with a conductor loss in the terahertz band. From the viewpoint of a conductor loss, the thickness of the dielectric forming the coupling wire 102 is preferably 1 $\mu$m or more. In an example, the dielectric thickness is set to 2 $\mu$m or more, and thus a loss by a conductor loss in the terahertz band is suppressed to about 20%. Similarly, from the viewpoint of a conductor loss, a wide interval in the thickness direction between the conductor forming the coupling wire 102 and the bias line 105 and conductor layer 121 can be ensured. The bias line 105 can be made to function as a low-impedance line almost up to a gigahertz band by setting the dielectric thickness to 2 $\mu$m or less, or 1 $\mu$m or less in an example. Even if the dielectric thickness is set to 2 $\mu$m or more, it is possible to suppress low-frequency oscillation by connecting, to the bias line 105, a shunt component formed by the resistance layer and the MIM capacitor to function as a low-impedance line.

Note that the length of the conductor of the coupling wire 102 is designed to satisfy a phase matching condition in one or both of the X direction and the Y direction in Fig. 3 if the adjacent antennas are connected by the coupling wire. The coupling wire 102 can be designed to have, for example, such length that the electrical length between the RTDs of the adjacent antennas is equal to an integer multiple of $2\pi$. That is, the length of the coupling wire 102 is set so that the length of a path via the coupling wire 102 when the RTDs are connected by the coupling wire 102 is equal to an integer multiple of the wavelength of a propagated electromagnetic wave. For example, in Fig. 3, the coupling wire 102ad extending in the X direction can be set to such length that the electrical length between the semiconductors 101a and 101d is equal to $4\pi$. Furthermore, the coupling wire 102ad extending in the Y direction can be set to such length that the electrical length between the semiconductors 101a and 101b is equal to $2\pi$. Note that the electrical length indicates a wiring length considering the propagation speed of the electromagnetic wave of the high frequency that propagates in the coupling wire 102. The electrical length of $2\pi$ corresponds to the length of one wavelength of the electromagnetic wave propagating in the coupling wire 102. With such design, the semiconductors 101 of the active antennas 11a to 11i are mutual injection-locked in the positive phase. Note that the error range of the electrical length within which mutual injection locking occurs is $\pm 1/4\pi$.

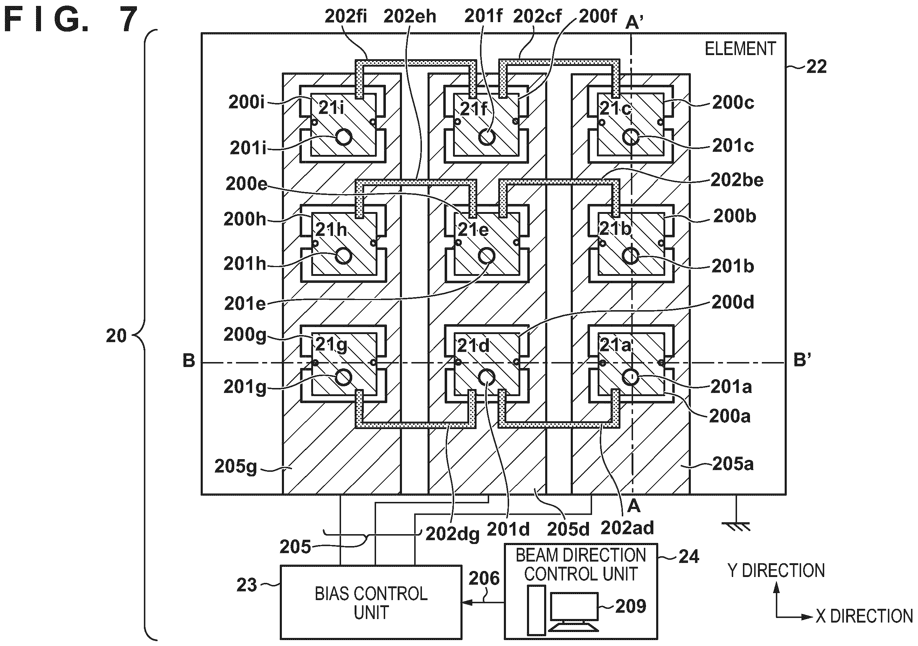

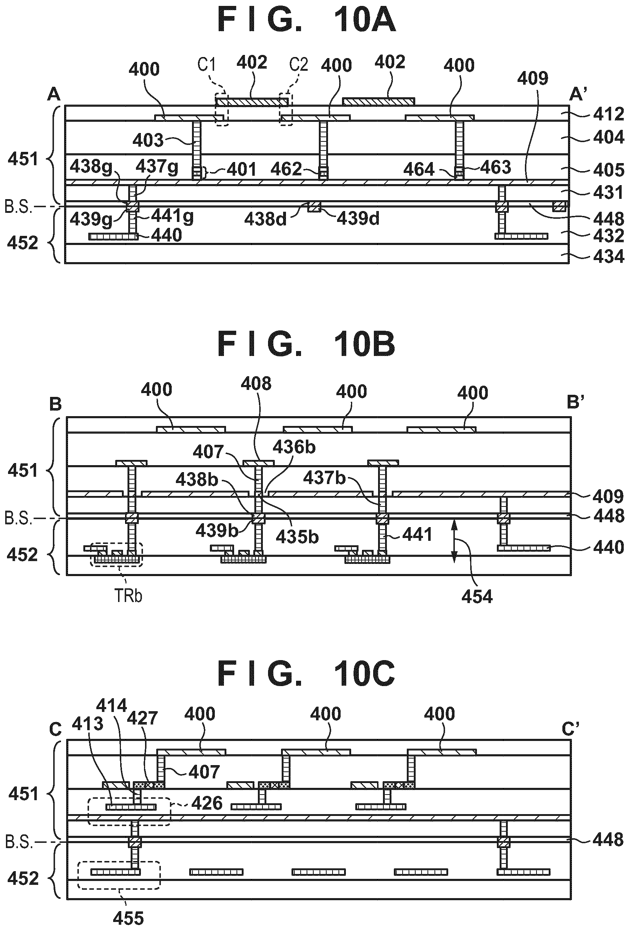

As shown in Figs. 3, 4A, and 4B, the element 12 is formed so that the bias line 105 arranged between the antennas applies the bias to each of the semiconductors 101 included in the active antennas 11a to 11i forming the antenna array 11. By separating the bias lines 105 as the wirings in the chip, driving in the same channel or individual driving by the bias control unit 13 is possible, thereby making it possible to control the driving method. It is possible to adjust the variation of the thickness or shape caused by formation, or a deviation in operating point among the antennas along with a wiring resistance and the like. This can cope with deviations in frequency and phase differences among the antennas caused by the increase in number of active antennas, thereby more easily obtaining the synchronization effect by the array. Note that the bias lines 105 need not always be arranged in the same layer, and need not be separated so as to individually control all the active antennas. For example, the bias line may be formed by stacking a multilayer wiring like an element 42 shown in Figs. 10A to 10C to be described later, or the bias line may be prepared for each column of antennas to apply the common bias to some antennas like an element 22 shown in Fig. 7 to be described later. In this case, by decreasing the power supply devices or wirings forming the bias control unit 13, it is possible to save the power of the antenna apparatus 10 and simplify the antenna apparatus 10.

(Bias Control Unit)

The bias control unit 13 is connected to the control line 106, and has a function of changing the bias to be applied to each of the semiconductors 101a to 101i by a signal received from the beam direction control unit 14. Note that to change the voltage for each semiconductor, the bias control unit 13 may use an individual power supply corresponding to the number of antennas or use, in combination, power supplies the number of which is smaller than the number of antennas, a variable voltage device, a variable resistor, a transistor, and the like. The bias control unit 13 can use these functions to apply different voltages to the bias lines 105a to 105i in parallel.

The admittance (YRTD) of the semiconductor 101 changes in accordance with the bias. This is because the depletion layer capacitance of the semiconductor 101 changes in accordance with the bias. Then, as described above, the oscillation frequency $f_{THz}$ of the active antenna is decided based on the admittance YRTD of the semiconductor 101. That is, the oscillation frequency $f_{THz}$ in one active antenna changes in accordance with the bias applied to the semiconductor 101. Note that as the bias voltage is increased, the oscillation frequency $f_{THz}$ becomes higher. The bias to be applied to the active antenna is decided within the range of the negative-resistance region of the semiconductor 101, and the change amount of the frequency is different depending on the area of the negative-resistance region. "The area of the negative-resistance region" indicates the magnitude of the voltage difference between the lower value and the upper value of the voltage of the negative-resistance region. In this embodiment, the bias control unit 13 can perform individual bias control for each active antenna via the bias line 105. Therefore, even if the two or more semiconductors 101 whose areas of the negative-resistance regions are different due to the variation of the dimension are included in the antenna array 11, it is possible to readily perform frequency control.

(Beam Direction Control Unit 14)

The beam direction control unit 14 is connected to the bias control unit 13 via the control line 106, and has a function of supplying a control signal to the bias control unit 13. The control signal supplied to the bias control unit 13 can be different depending on a device used as the bias control unit 13. For example, in a case where the device used as the bias control unit 13 is formed using a transistor, a voltage signal applied to the gate of the transistor may be supplied as the control signal from the beam direction control unit 14 to the bias control unit 13. The beam direction control unit 14 can have, for example, an information table that associates the bias applied to each active antenna with the directivity of the beam. In this case, the beam direction control unit 14 can supply, to the bias control unit 13, such control signal that an application voltage necessary for beamforming is set in accordance with the information table. The beam direction control unit 14 may have an information table that associates the bias applied to each active antenna with a phase expected to be obtained. In this case, for example, the beam direction control unit 14 decides the beam to be formed (the directivity direction of the beam) in accordance with the state of the transmission path with a communication partner apparatus, and decides a phase value to be set in each active antenna in correspondence with the beam. Then, with reference to the information table, the beam direction control unit 14 can specify, for each active antenna, the bias to be applied so that the phase is the decided phase value, and transmit a control signal corresponding to the specifying result to the bias control unit 13.

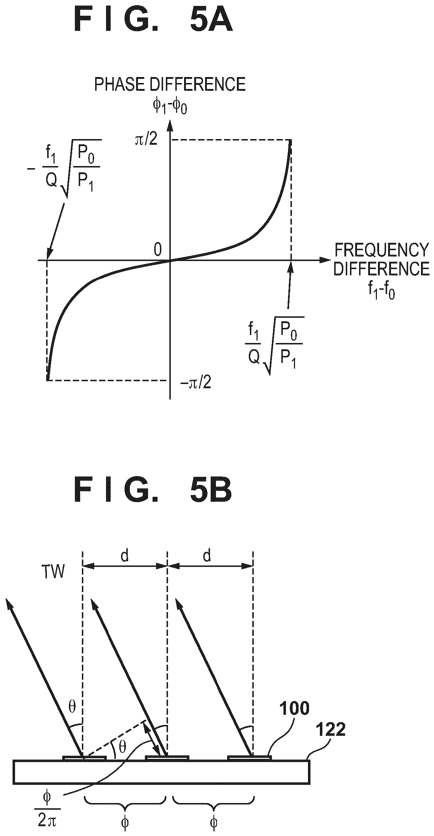

A change in the phase caused by a change in the bias in the active antenna will be described with reference to Fig. 5A. The oscillation frequency of the single active antenna is decided by the resistance component and the LC component of the semiconductor 101 and the resistance component and the LC component caused by the structure of the antenna 100. Since the depletion layer capacitance as the semiconductor characteristic of each of the semiconductors 101a to 101i changes depending on the applied bias, the oscillation frequency of each of the active antennas 11a to 11i changes in accordance with the applied bias. In this embodiment, as described above, the active antennas 11a to 11i are coupled by the coupling wires 102ab to 102hf, and oscillate at the same oscillation frequency $f_0$ by a mutual injection locking phenomenon. In this example, assume, for example, that the active antenna 11a oscillates at the frequency $f_1$ by the applied bias, and then oscillates at the frequency $f_0$ by a mutual injection locking phenomenon with the remaining active antennas 11b to 11i.

A relational expression of the phase and a difference in angular velocity between two oscillators, which is described in NPL 2, is applied to this embodiment. Then, a phase difference $\varphi_1$ of the active antenna 11a is calculated based on a frequency difference between the frequency $f_0$ at which the antenna array 11 oscillates by mutual injection locking shown in Fig. 5A and the oscillation frequency $f_1$ when the active antenna 11a does not perform mutual injection locking by:

$$\phi_1 = \sin^{-1}\left(Q\sqrt{\frac{P_0}{P_1}} \times \frac{f_1 - f_0}{f_1}\right) \quad ...(1)$$

Note that $\varphi_1$ represents the oscillation phase of the active antenna 11a, and $P_1$ represents oscillation power. In addition, $P_0$ represents the oscillation power of the antenna array 11, and Q represents the Q value of the active antenna 11a. The Q value becomes higher as the frequency spectrum is sharper, and is used as an output index of the oscillation circuit. As shown in Fig. 5A, the phase difference $\varphi_1$ can be changed within the range of $-\pi/2$ to $\pi/2$. Furthermore, the remaining active antenna 11b to 11i can similarly be oscillated by changing the phase differences.

Subsequently, as an example, by focusing on the three active antennas 11a to 11c taken along a line A - A' in Fig. 3, the principle of inclining a beam from a direction vertical to the substrate when these active antennas emit electromagnetic waves will be described with reference to Fig. 5B. For example, assume that the bias control unit 13 increases stepwise the bias to be applied to each of the active antennas 11a to 11c in the A - A' direction. That is, assume that the bias to be applied to the active antenna 11a is lowest, the bias to be applied to the active antenna 11c is lowest, and the bias to be applied to the active antenna 11b is intermediate between them. In this case, the oscillation frequencies $f_1$ to $f_3$ of the respective active antennas 11a to 11c have a relationship of $f_1 < f_2 < f_3$. In this embodiment, as described above, the semiconductors 101a to 101c included in the active antennas 11a to 11c inject power via the coupling wires 102ab and 102bc, and the oscillation frequency becomes $f_0$ by a mutual injection locking phenomenon. At this time, when the oscillation frequency $f_2$ of the single active antenna 11b is equal to $f_0$, a phase difference $\varphi_2$ of the active antenna 11b after mutual injection locking is 0. On the other hand, the phase difference $\varphi_1$ of the active antenna 11a and a phase difference $\varphi_3$ of the active antenna 11c after mutual injection locking are determined based on the oscillation frequencies $f_1$ and $f_3$ by equation (1) above. In this case, the phase differences between the active antenna 11b and the active antennas 11a and 11c are given by $\varphi_2 - \varphi_1 = -\varphi_1$ and $\varphi_3 - \varphi_2 = \varphi_3$, respectively. It is assumed that the oscillation frequency $f_2$ of the single active antenna 11b is often not equal to $f_0$. In this case, the phase difference $\varphi_2$ of the active antenna 11b is determined, similar to the active antennas 11a and 11c. Then, the phase differences between the active antenna 11b and the active antennas 11a and 11c are given by $\varphi_2 - \varphi_1$ and $\varphi_3 - \varphi_2$, respectively. However, the relationship between $\varphi_2 - \varphi_1$ and $\varphi_3 - \varphi_2$ is important for beamforming and even if $\varphi_2$ common to both the expressions is assumed to be 0, there is no substantial difference. Therefore, $\varphi_2 = 0$ is set.

Fig. 5B shows direction control of electromagnetic waves emitted from the active antennas 11a to 11c whose phase differences are specified as described above. A case where the distances between the adjacent active antennas is commonly d and a radio wave is output in a direction $\theta$ will be examined. To emit a radio wave in the direction $\theta$, at a timing when the antenna arranged on the leftmost side emits a radio wave in a phase $\alpha$, the phase of a radio wave that has emitted from the antenna arranged on the right side of the antenna and traveled by a distance of $d \times \sin\theta$ needs to be $\alpha$. Furthermore, the phase of a radio wave that has emitted from the antenna arranged on the rightmost side and traveled by a distance of $2d \times \sin\theta$ also needs to be $\alpha$. Assume that the phase of a radio wave emitted from the second antenna from the left is changed by $\varphi$. At this time, when $\lambda$ represents the wavelength of the radio wave, if $\lambda \times (\varphi/2\pi) = d \times \sin\theta$ holds, the radio wave emitted from the second antenna from the left coincides with the radio wave emitted from the leftmost antenna in phase at a position where the radio wave emitted from the second antenna from the left travels by a distance of $d \times \sin\theta$. Therefore, by determining the emission direction $\theta$ of the radio wave, the phase difference to be set between the adjacent antennas is decided by:

$$\phi = \frac{2\pi d}{\lambda} \sin\theta \ldots (2)$$

The phase difference between the second antenna from the left and the rightmost antenna is similarly determined. Therefore, for example, it is possible to direct the beam in the direction $\theta$ by performing bias control so as to obtain such $\varphi_1$ and $\varphi_3$ that $\varphi_2 - \varphi_1 = -\varphi_1$ satisfies $\varphi$ of equation (2) above and $\varphi_3 - \varphi_2 = \varphi_3$ satisfies $\varphi$ of equation (2) above. That is, based on the predetermined direction $\theta$ in which the beam is to be directed, the phase differences to be set between the plurality of active antennas are decided, and the oscillation frequency of the oscillator of each active antenna is set to obtain the phase difference. Note that the direction $\theta$ of the antenna can be changed by the shape and type of the antenna and an array arrangement. In this way, the antenna apparatus 10 according to this embodiment can perform beamforming at an arbitrary angle by controlling the bias to be applied to the oscillator (semiconductor 101) included in each active antenna.

(Practical Materials and Structure Dimensions)

A practical example of the antenna array 11 will be described. The antenna array 11 is a semiconductor device that can perform single-mode oscillation in a frequency band of 0.45 THz to 0.50 THz. The substrate 122 is a semi-insulating InP substrate. The semiconductor 101 is formed from a multiquantum well structure by InGaAs/AlAs lattice-matched on the substrate 122, and an RTD having a dual barrier structure is used in this embodiment. This is also called the semiconductor heterostructure of the RTD. As the current-voltage characteristic of the RTD used in this embodiment, the measurement value of the peak current density is 9 mA/$\mu$m$^2$, and the measurement value of the differential negative conductance per unit area is 10 mS/$\mu$m$^2$. The semiconductor 101 is formed in a mesa structure, and is formed from the semiconductor structure including the RTD, and an ohmic electrode for electrical connection to the semiconductor structure. The mesa structure has a circular shape with a diameter of 2 $\mu$m, and the magnitude of the differential negative resistance of the RTD at this time is about -30 $\Omega$ per diode. In this case, it is estimated that the differential negative conductance (GRTD) of the semiconductor 101 including the RTD is about 30 mS and the diode capacity (CRTD) is about 10 fF.

The active antenna 11 is a patch antenna having a structure in which the dielectric layers 119 and 120 are sandwiched by the conductor 100 as a patch conductor and the conductor layer 121 as a ground conductor. This patch antenna is a square patch antenna in which one side of the conductor 100 is 150 $\mu$m, and the resonator length (L) of the antenna is 150 $\mu$m. In the antenna, the semiconductor 101 including the RTD is integrated.

The conductor 100 as a patch conductor is formed by a metal layer (a metal containing Ti/Au (=5/300 nm)) mainly including an Au thin film with a low resistivity. The conductor layer 121 as a ground conductor is formed by a Ti/Pd/Au layer (20/20/200 nm) and a semiconductor including an n+-InGaAs layer (100 nm) with an electron density of $1 \times 10^{18}$ cm$^{-3}$ or more, and the metal and the semiconductor are connected with low-resistance ohmic contact. The dielectric layer 119 is made of BCB (benzocyclobutene of the Dow Chemical Company, $\varepsilon_{r1} = 2$) with a thickness of 5 $\mu$m. Each of the dielectric layer 118 and 120 is formed by silicon oxide (SiO$_2$, plasma CVD, $\varepsilon_{r2} = 4$) with a thickness of 1 $\mu$m, and the total film thickness of the two layers is 2 $\mu$m.

On the periphery of the semiconductor 101, the conductor layer 121, the semiconductor 101, the via 114 formed by a conductor containing Cu, the conductor 100, and the conductor of the coupling wire 102 are stacked in this order from the side of the substrate 122, and are electrically connected. The RTD as the semiconductor 101 is arranged at a position shifted from the center of gravity of the conductor 100 by 40% (60 $\mu$m) of one side of the conductor 100 in the resonance direction (that is, the A - A' direction in Fig. 3). The input impedance when supplying a high frequency from the RTD to the patch antenna is decided based on the position of the RTD in the antenna. As shown in Fig. 4B, the conductor 100 is connected, via the via 110 formed by Cu, to the wiring 111 existing in the same layer as that of the bias line 105 arranged on the dielectric 120. The bias line 105 and the wiring 111 are formed by a metal layer containing Ti/Au (= 5/300 nm) stacked on the dielectric layer 120. The wiring 111 is connected to the bias control unit 13 via the bias line 105 as a common wiring formed in the chip. The active antenna is designed to obtain oscillation with power of 0.2 mW at the frequency $f_{THz}$ = 0.5 THz by setting a bias in the negative-resistance region of the RTD included in the semiconductor 101.

Each of the vias 110 and 114 has a columnar structure having a diameter of 10 $\mu$m. The wiring 111 is formed by a pattern formed by a metal layer containing Ti/Au (= 5/300 nm) and having a width of 10 $\mu$m in the resonance direction (= A - A' direction) and a length of 75 $\mu$m. The via 110 is connected to the conductor 100 at the center in the resonance direction (= A - A' direction) and at the end of the conductor 100 in the C - C' direction. This connection position corresponds to the node (that is, a position at which the amplitude of the standing wave always becomes zero) of the electric field of the standing terahertz wave of the frequency $f_{THz}$ in the active antenna 11a.

The antenna array 11 is an antenna array in which active antennas are arranged in a matrix. In this embodiment, as an example, the antenna array in which the nine active antennas 11a to 11i are arranged in a 3×3 matrix has been described. Each active antenna is designed to singly oscillate the terahertz wave of the frequency $f_{THz}$, and the active antennas are arranged at a pitch (interval) of 340 $\mu$m both in the A - A' direction and the B - B' direction. The adjacent antennas are mutually coupled by the coupling wire 102 including the conductor made of Ti/Au (= 5/300 nm), and are mutual injection-locked to oscillate by the biases for driving within the range of the oscillation frequency $f_{THz}$ = 0.5 $\pm$ 0.02 THz.

(Manufacturing Method)

A manufacturing method (forming method) of the antenna array 11 will be described next.

(1) First, on the substrate 122 made of InP, an InGaAs/AiAs-based semiconductor multilayer film structure forming the semiconductor 101 including the RTD is formed by epitaxial growth. This is formed by Molecular Beam Epitaxy (MBE), Metal Organic Vapor Phase Epitaxy (MOVPE), or the like.
(2) The ohmic electrode Ti/Pd/Au layer (20/20/200 nm) forming the semiconductor 101 is deposited by sputtering.
(3) The semiconductor 101 is formed in a circular mesa shape with a diameter of 2 $\mu$m, thereby forming a mesa structure. To form the mesa shape, photolithography and dry etching by ICP (inductively coupled plasma) are used.
(4) After the conductor layer 121 is formed on the substrate 122 on the etched surface by a lift-off process, silicon oxide with a thickness of 2 $\mu$m is deposited by the plasma CVD method to obtain the dielectric layer 120.
(5) A Ti/Au layer (= 5/300 nm) is formed as a conductor forming the bias line 105 and the wiring 111 on the dielectric layer 120.
(6) BCB with a thickness of 5 $\mu$m is embedded and planarized using spin coating and dry etching to obtain the dielectric layer 119.
(7) BCB and silicon oxide of the portions forming the vias 110 and 114 are removed by photolithography and dry etching to form via holes (contact holes). At this time, by using photolithography including grayscale exposure, it is also possible to arbitrarily control the taper angles of the via holes formed in the dielectric layers 119 and 120.
(8) The vias 110 and 114 are formed in the via holes by conductors containing Cu. To form the vias 110 and 114, Cu is embedded in the via holes and planarized using sputtering, electroplating, and chemical mechanical polishing.
(9) An electrode Ti/Au layer (= 5/300 nm) is deposited by sputtering to obtain the conductor 100 of each antenna. The conductor 100 is patterned by photolithography and dry etching by ICP (inductively coupled plasma).
(10) Silicon nitride with a thickness of 0.1 $\mu$m is deposited by the plasma CVD method to obtain the dielectric layer 118. An electrode Ti/Au layer (= 5/300 nm) is deposited by sputtering to obtain the conductor forming the coupling wire 102. The conductor of the coupling wire 102 is patterned by photolithography and dry etching by ICP (inductively coupled plasma).
(11) Finally, the bias line 105 and the bias control unit 13 are connected by wire bonding or the like, thereby completing the antenna array 11.

Note that the bias control unit 13 supplies power to the antenna apparatus 10. Normally, if a bias is applied to supply a bias current in the differential negative-resistance region, the antenna apparatus 10 operates as an oscillator.

[Second Embodiment]

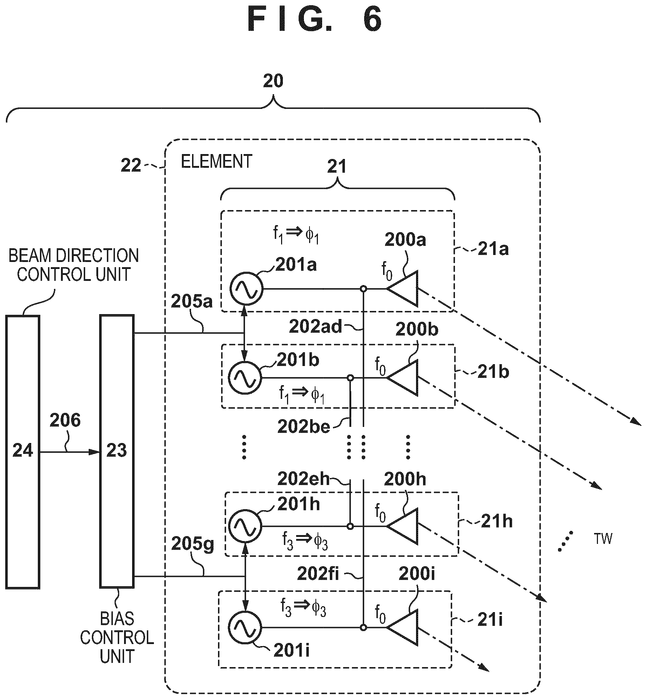

The above embodiment has explained the arrangement in which the oscillation frequency of each of the oscillators included in the plurality of active antennas can individually (independently) be controlled. This embodiment will describe an arrangement in which some active antennas are grouped and common control is performed for the active antennas. Fig. 6 is a block diagram for explaining the system configuration of an antenna apparatus 20 according to this embodiment, and Fig. 7 is a schematic plan view showing the antenna apparatus 20 when viewed from above. Note that a detailed description of the same components as those of the antenna apparatus 10 among the components of the antenna apparatus 20 according to this embodiment will be omitted for the sake of descriptive simplicity.

As shown in Fig. 6, similar to the antenna apparatus 10 of the first embodiment, the antenna apparatus 20 of this embodiment includes an element 22 including an antenna array 21 in which active antennas 21a to 21i are arranged in an array, a bias control unit 23, and a beam direction control unit 24. These functions roughly have the same functions as those in the antenna apparatus 10 of the first embodiment. That is, the beam direction control unit 24 is connected to the bias control unit 23 via a control line 206, and supplies, to the bias control unit 23, a control signal to direct a beam in a predetermined direction. The bias control unit 23 is configured to supply, via each bias line 205, a bias to each of oscillators 201a to 201i included in the active antennas 21a to 21i. The active antennas 21a to 21i include the oscillators 201a to 201i and antennas 200a to 200i, respectively.

In this embodiment, a first group of antennas mutually connected by coupling wires 202 for mutual injection locking and a second group of antennas for which the oscillation frequency is commonly controlled are set. For example, assume that the nine active antennas 21a to 21i are arranged in a $3 \times 3$ matrix, as shown in Fig. 7. At this time, the active antennas arranged in the X direction are coupled by the coupling wires 202 to establish synchronization by mutual injection locking, and the common bias line is used to perform common oscillation frequency control for the active antennas arranged in the Y direction. In the example shown in Fig. 7, the active antennas 21a, 21d, and 21g are mutually coupled using coupling wires 202ad and 202dg. Similarly, the active antennas 21b, 21e, and 21h are mutually coupled using coupling wires 202be and 202eh, and the active antennas 21c, 21f, and 21i are mutually coupled using coupling wires 202cf and 202fi. Then, mutual injection locking is established among the active antennas coupled by the coupling wires. On the other hand, the active antennas 21a, 21b, and 21c are connected to a common bias line 205a. The active antennas 21d, 21e, and 21f are connected to a common bias line 205d, and the active antennas 21g, 21h, and 21i are connected to a common bias line 205g.

As described above, the active antennas arranged in the X direction emit radio waves at the same frequency when synchronization of the oscillation frequency is established by mutual injection locking. On the other hand, when the active antennas arranged in the Y direction use the common bias line 205, the phase differences among the active antennas coupled by the coupling wires 202 can be made common. That is, the active antennas 21a, 21d, and 21g appropriately set the oscillation phase differences among them while oscillating at an oscillation frequency $f_{01}$ by mutual injection locking, thereby making it possible to direct a beam in an arbitrary direction on the X-Z plane. Note that Z represents an axis in a direction from the back to the front, which vertically intersects the X-Y plane, and the X-Z plane is a plane designated by the X-axis and the Z-axis. Furthermore, the relationship between the oscillation phase difference and the direction of the beam is determined in accordance with equation (2) above. In addition, the active antennas 21b, 21e, and 21h can direct a beam in the same direction on the X-Z plane as that of the beam formed by the active antennas 21a, 21d, and 21g while oscillating at an oscillation frequency $f_{02}$ by mutual injection locking. That is, since the bias line 205 is made common, the phase difference between the active antennas 21b and 21e is equal to that between the active antennas 21a and 21d. Similarly, the phase difference between the active antennas 21e and 21h is equal to that between the active antennas 21d and 21g. Similarly, the active antennas 21c, 21f, and 21i can direct a beam in the same direction on the X-Z plane as that of the beam formed by the active antennas 21a, 21d, and 21g while oscillating at an oscillation frequency $f_{03}$ by mutual injection locking. Note that in an environment in which the individual difference of the oscillator 201 is sufficiently small, for example, in the three antenna groups of the active antennas 21a to 21c, the active antennas 21d to 21f, and the active antennas 21g to 21i, the active antennas oscillate at almost the same oscillation frequency. Therefore, the oscillation frequencies $f_{01}$ to $f_{03}$ after mutual injection locking are almost the same. Furthermore, even in an environment in which there exists a certain individual difference, for example, it is expected that the oscillation frequencies $f_{01}$ to $f_{03}$ after mutual injection locking are almost the same by averaging in the group of the active antennas as the target of mutual injection locking.

As described above, the three groups each including the three active antennas arranged in the X direction operate to direct the beams in the same direction by a bias for each group of active antennas arranged in the Y direction. As a result, for example, it is possible to use the antenna apparatus in an environment in which it is only necessary to control the direction of the beam on the X-Z plane and to form the element 22 with a relatively simple arrangement. By reducing power consumption in the coupling wires 202 by decreasing the formed coupling wires 202, it is possible to suppress a power loss in the overall antenna apparatus 20. Furthermore, since targets to be controlled by the bias control unit 23 decrease, it is possible to decrease the power supplies and power supply circuits of the bias control unit 23, thereby reducing the weight of the antenna apparatus 20.

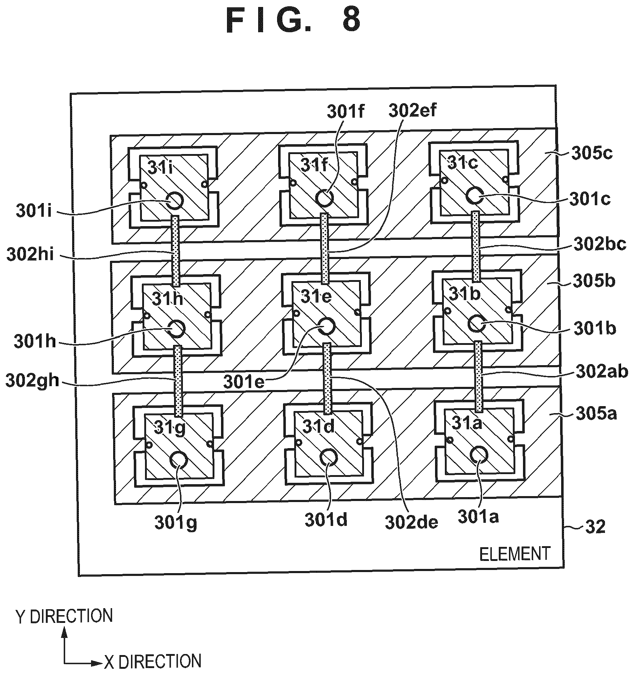

Note that as shown in Fig. 8, three groups each including three active antennas arranged in the Y direction are configured to operate to direct beams in the same direction by a bias for each group of active antennas arranged in the X direction. With this arrangement, it is possible to control the direction of the beam on the Y-Z plane. Generally speaking, in an antenna array in which active antennas are arranged in a matrix, the active antennas arranged in the first direction are coupled by coupling wires and the active antennas arranged in the second direction different from the first direction are not coupled by coupling wires. This synchronizes the oscillation frequencies of the active antennas by mutual injection locking only among the active antennas arranged in the first direction. Furthermore, the oscillation frequency before synchronization is made common to the active antennas arranged in the second direction. This can make the oscillation frequency, before occurrence of mutual injection locking caused by coupling in the first direction, common to the active antennas arranged in the second direction. Thus, in a case where a plurality of groups each including active antennas arranged in the first direction are formed, the plurality of groups can direct beams in the same direction on a plane including the first direction and a direction perpendicular to the antenna apparatus.

[Third Embodiment]

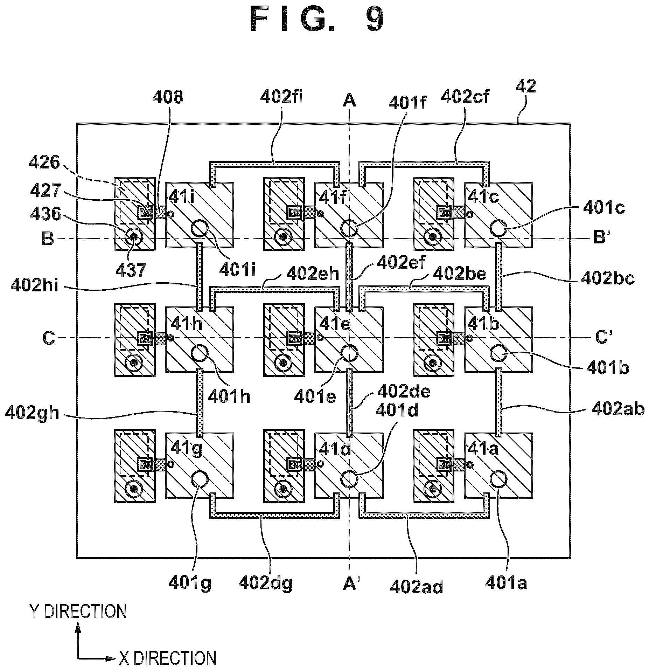

Each of the above-described embodiments has explained an example in which an element is formed on one substrate. This embodiment will describe an example in which an element is formed by combining a plurality of substrates. Fig. 9 is a schematic plan view of an element 42 according to this embodiment. Figs. 10A to 10C are sectional views of the element 42. Note that a detailed description of the same components as those of the antenna apparatus 10 will be omitted for the sake of descriptive simplicity.

As shown in Fig. 9, the element 42 also includes an antenna array in which nine active antennas 41a to 41i each including a conductor 400 and a semiconductor 401 are arranged in a $3 \times 3$ matrix. Similar to each of the above-described embodiments, the active antennas 41a to 41i are mutually connected via coupling wires 402, and configured to synchronize oscillation frequencies by mutual injection locking. Each active antenna includes a through via 437, an opening 436, a MIM capacitor 426, a resistance layer 427, and a bias line 408.

The layer arrangements of the A - A' section, B - B' section, and C - C' section in Fig. 9 will be described with reference to Figs. 10A to 10C, respectively. Each of the active antennas 41a to 41i includes at least the conductor 400 as an upper conductor of a patch antenna, a conductor 409 serving as a GND layer and a reflector layer, and the semiconductor 401 arranged between them. Note that the semiconductor 401 is a compound semiconductor, and uses, for example, a Resonant Tunneling Diode (RTD) as a semiconductor structure 462. Each of the active antennas 41a to 41i further includes a via 403 for connection between the conductor 400 and the semiconductor 401. In addition, an upper conductor of the coupling wire 402 for coupling the conductors 400 of the active antennas is arranged. The bias line 408 is arranged between the conductors 400 and 409, and the bias line 408 is located at the intermediate point between dielectric layers 404 and 405. The bias line 408 is connected to the conductor 400 via a via 407. Furthermore, the conductor 409 serving as the GND layer is grounded.

In the semiconductor 401, an upper electrode layer 463, a semiconductor structure 462, and a lower electrode layer 464 are stacked in this order from the side of the conductor 400, and are electrically connected. The semiconductor structure 462 is a semiconductor structure having nonlinearity or an electromagnetic wave gain with respect to a terahertz wave, and an RTD is used in this embodiment. The upper electrode layer 463 and the lower electrode layer 464 have a structure serving as an electrode layer for connecting contact electrodes (ohmic and Schottky electrodes) above and below the semiconductor structure 462 and upper and lower wiring layers in order to apply a potential difference or a current to the semiconductor structure 462. The upper electrode layer 463 and the lower electrode layer 464 can be made of a metal material (Ti/Pd/Au/Cr/Pt/AuGe/Ni/TiW/Mo/ErAs or the like) known as an ohmic electrode or Schottky electrode, or a semiconductor doped with impurities.

One active antenna is formed from the conductor 400 of the antenna, the semiconductor 401, the conductor 409 (reflector), the dielectric layers 404 and 405, and the via 403 that connects the conductor 400 and the semiconductor 401. To apply a control signal to the semiconductor 401, the bias line 408, the via 407, the MIM capacitor 426, and the resistance layer 427, which are individually provided for each active antenna, are connected to the active antenna, as shown in Figs. 10B and 10C. The MIM capacitor 426 is a capacitive element that sandwiches a dielectric layer by metal elements, and is arranged to suppress a low-frequency parasitic oscillation caused by a bias circuit. The active antennas are connected by the coupling wires 402 for establishing synchronization between the antennas at a terahertz frequency.

A bonding surface B.S. is provided on the lower surface of a first substrate 451 on which the antenna array and the semiconductor are integrated, and the first substrate 451 is bonded, via the bonding surface B.S., to a second substrate 452 including the integrated circuit. At this time, "bonded" is defined as sharing the same bonding surface B.S. by the first substrate 451 and the second substrate 452. The bonding second substrate 452 is formed by including the second semiconductor substrate as a base material and an integrated circuit region where a driving circuit is formed. Bonding is performed by metal bonding such as Cu-Cu bonding, insulator bonding such as $SiO_x$-$SiO_x$ bonding, adhesive bonding

using an adhesive such as BCB, hybrid bonding as a combination of these, or the like. As a bonding process, low-temperature bonding using plasma activation or conventional thermocompression bonding is used. A method of bonding semiconductor wafers of the same size, a method of bonding semiconductor wafers of different sizes, a method (tiling) of separately bonding a plurality of semiconductor chips to a wafer, or the like is used.

In the antenna array 41, as a dielectric layer 431 of the first substrate 451 on which the semiconductor 401 is integrated, a semi-insulating InP substrate (4 inches) as a compound semiconductor substrate on which the semiconductor 401 is crystal-grown is used. In this embodiment, the dielectric layer 431 will sometimes be referred to as the "compound semiconductor substrate 431" hereinafter. From the viewpoint of reduction of wiring inductance, the thickness of the compound semiconductor substrate 431 is 100 $\mu$m or less, and in an example, 10 $\mu$m or less. The board thickness is the wavelength or less of the terahertz wave to be operated, is typically $\lambda$/10 or less, and is, in an example, $\lambda$/20 or less. The bonding surface B.S. is provided on the lower surface of the compound semiconductor substrate 431 as a base material of the first substrate 451, and the second substrate 452 including an integrated circuit is bonded. In this embodiment, as an example, a tiling method of bonding the cut first substrate 451 to the 12-inch Si integrated circuit substrate using hybrid bonding of Cu-Cu bonding and SiO$_x$-SiO$_x$ bonding is used.

In the first substrate 451, a dielectric layer 448, the compound semiconductor substrate 431, the conductor 409, the dielectric layer 405, the dielectric layer 404, and a dielectric layer 412 are stacked in this order from the side of the bonding surface B.S. to the second substrate 452. In the dielectric layers 405 and 404, the vias 403 and 407, the conductor 400, and the bias line 408 are formed. In the dielectric layer 412, the conductor of the coupling wire 402 is formed. The surface of the first substrate 451 on the side of the bonding surface B.S. to the second substrate 452 is arranged at a position facing the semiconductor 401 via the conductor 409 as the reflector. The through via 437 formed to extend through the InP semiconductor 431 is formed in the compound semiconductor substrate 431. As the material of the through via 437, for example, Cu or Au is used. The dielectric layer 448 and an electrode layer 438 for bonding are planarized at the bonding surface B.S., and undergoes a bonding process in a state in which the flat bonding surface B.S. is exposed. In the second substrate 452, a second semiconductor substrate 434 as a base material and a dielectric layer 432 are stacked in this order, and a conductor 440 forming a multilayer wiring, a via 441, and a bonding electrode layer 439 are formed in the dielectric layer 432. The dielectric layer 432 and the electrode layer 439 are planarized at the bonding surface B.S., and undergoes a bonding process in a state in which the flat bonding surface B.S. is exposed. For the dielectric layers 432 and 448, an inorganic insulating material such as silicon oxide (SiO$_x$), silicon nitride (Si$_x$N$_y$), silicon oxynitride (SiON), carbon-containing silicon oxide (SiOC), or silicon carbide (SiC) is used.

Referring to Fig. 10A, the conductor 409 is electrically connected to a via 437g formed in the compound semiconductor substrate 431 and a bonding electrode layer 437g formed in the dielectric layer 448 in this order to reach the bonding surface B.S. Furthermore, the conductor 440 as GND of the second substrate 452 is connected to a via 441g formed in an integrated circuit region 454 and a bonding electrode layer 439g in this order to reach the bonding surface B.S. The electrode layer 438g of the first substrate 451 and the electrode layer 439g of the second substrate 452 are electrically connected at the bonding surface B.S., thereby sharing the GND potential of both the substrates.

Referring to Fig. 10B, the bias line 408 connected to the semiconductor 401 of the first substrate 451 is electrically connected to a transistor TRb (MOSFET) for bias control provided in the integrated circuit region 454 of the second substrate 452. The bias line 408 of the first substrate 451 is electrically connected to the via 407, a wiring layer 435 provided in the opening 436 of the conductor 409, a through via 437b, and a bonding electrode layer 438b formed in the dielectric layer 448 in this order to reach the bonding surface B.S. Similarly, the transistor TRb formed in the integrated circuit region 454 of the second substrate 452 is connected to a via 441b formed in the integrated circuit region 454 and a bonding electrode layer 439b in this order to reach the bonding surface B.S.

Referring to Fig. 10C, to apply a control signal to the semiconductor 401, the bias line 408, the via 407, a via 414, the MIM capacitor 426, and the resistance layer 427, which are individually provided for each antenna, are connected to the first substrate 451. The MIM capacitor 426 is formed by sandwiching a dielectric layer by a conductor 413 and the conductor 409 as a GND layer. Similarly, a MIM capacitor 455 is provided in the second substrate 452.

The bias line 408 of the antenna array and a transistor TRa of the integrated circuit region 454 are electrically connected at the bonding surface B.S., and are rendered conductive, thereby making it possible to individually apply a control signal to each active antenna. The MOSFET of the transistor TRb also serves as a bias control unit, and operates as a switching regulator, thereby making it possible to individually control a bias to the semiconductor 401 via the bias line 408. Alternatively, an arrangement in which a terminal for applying a bias is additionally provided on the second substrate 452 and the transistor TRa is operated as an analog switch that individually switches ON/OFF of the bias to the active antenna to supply a voltage from the outside of the second substrate 452 may be adopted.

Note that as an example of enhancing the bonding strength, dummy electrode layers 438d and 439d not connected to signal lines may be provided on the bonding surface B.S. By widely distributing the dummy electrode layers 438d and 439d in a region where no wiring electrode is necessary, the bonding strength can be enhanced, thereby improving the yield and reliability. Furthermore, by widely distributing and arranging the GND electrode layers 438g and 439g and the dummy electrode layers 438d and 439d over the entire bonding surface B.S., it is possible to reduce the influence of electromagnetic wave noise on the terahertz antennas of the first substrate 451, which is caused by the integrated circuit of the second substrate 452.

In the active array antenna of the terahertz wave, to individually control each antenna, a plurality of wirings such as a bias line for supplying power to the compound semiconductor, a coupling wire for synchronization between the antennas, and a control line for injecting a baseband signal into the antenna are necessary. On the other hand, to improve the gain of the antenna, it is necessary to increase the number of antennas but wiring inductance caused by the layout increases along with an increase in number of antennas, thereby interfering with implementation of a high frequency. To the contrary, in this embodiment, the antenna substrate (first substrate 451) of the compound semiconductor including the antenna array and the Si integrated circuit substrate 452 are stacked by a semiconductor bonding technique. This eliminates the need to take an implementation form of integrating or externally connecting a peripheral circuit necessary to control the active antenna array onto the compound semiconductor substrate. This can suppress an increase in inductance caused by wiring routing, and typically suppress inductance to 1 nH or less, thereby suppressing a signal loss or signal delay of the baseband signal subjected to modulation control at a high frequency of 1 GHz or more.

Since, on the periphery of the active antenna, there is no circuit that is not related to transmission/reception of the terahertz wave or the number of such circuits can be made sufficiently small, noise by unnecessary reflection is reduced, thereby making it possible to exhibit the characteristic of the antenna at the maximum. If the bias signal of the compound semiconductor and the like are controlled for each antenna, each bias wiring needs to be individually arranged. To the contrary, in this embodiment, the first substrate 451 including the antenna array can directly be connected to the integrated circuit of the second substrate 152 via the through vias 437. If the antenna array is used, a wiring can be arranged on the rear side (that is, the rear side of the conductor 409 as a reflector) of the antenna substrate (first substrate 451) of the compound semiconductor including the antenna array. Therefore, it is possible to increase the number of active antennas included in the antenna array without receiving the influence of the layout. Furthermore, the second substrate 452 including the integrated circuit can form a complex circuit such as a detection circuit or a signal processing circuit using the conventional CMOS integrated circuit technique. Therefore, by using the arrangement described in this embodiment, it is possible to sophisticate the antenna apparatus and reduce the cost, and thus readily use an electromagnetic wave in the terahertz band.

[Fourth Embodiment]

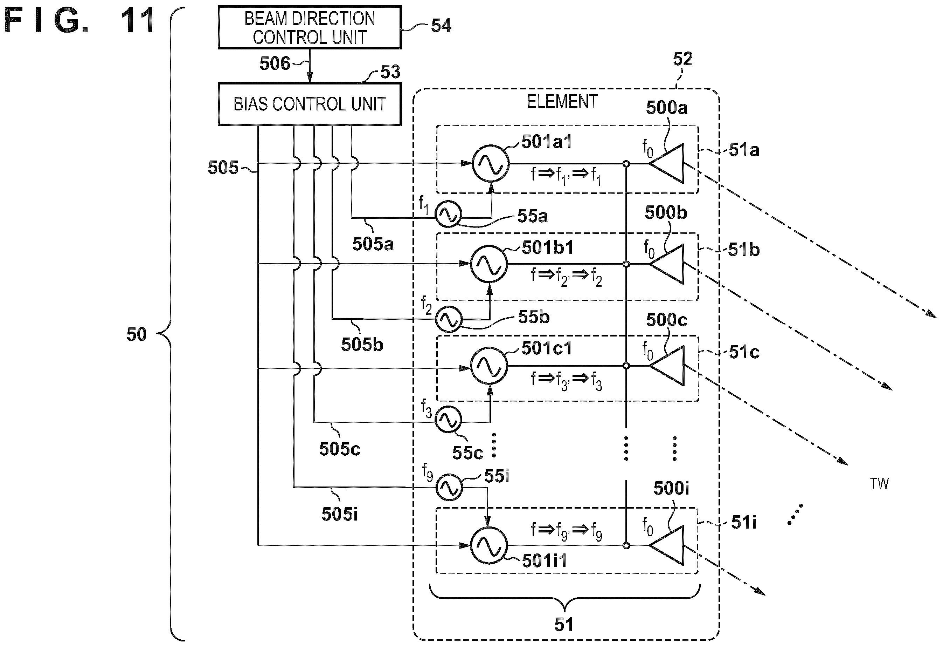

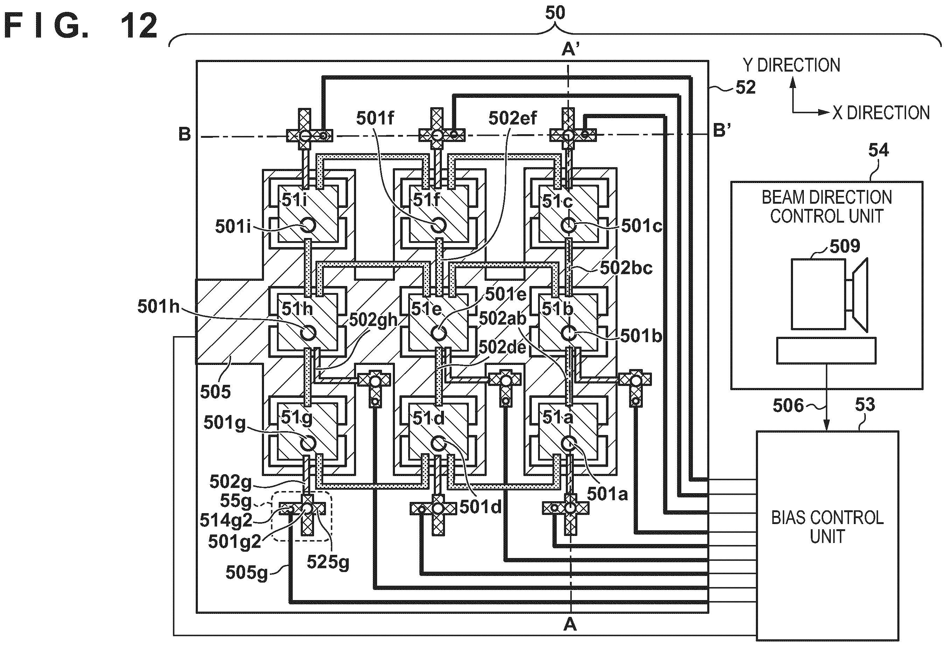

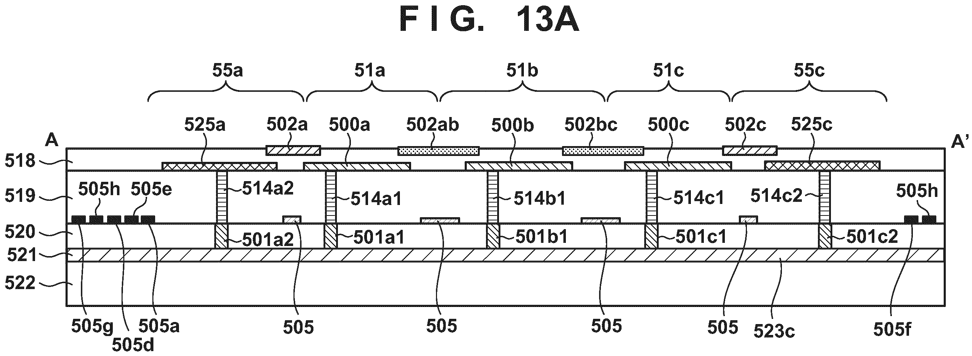

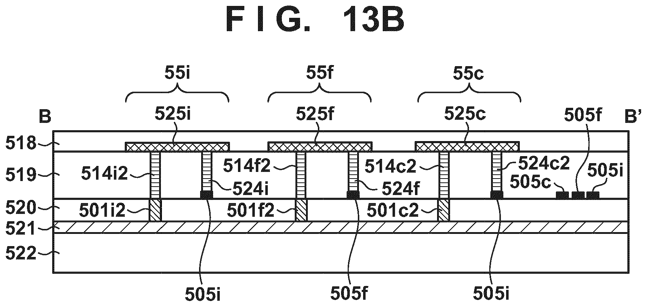

The arrangement of another antenna apparatus 50 will be described with reference to Figs. 11 to 13A and 13B. Fig. 11 is a block diagram for explaining the system configuration of the antenna apparatus 50. Fig. 12 is a schematic plan view showing the antenna apparatus 50 when viewed from above. Figs. 13A and 13B are sectional views of an element 52. Note that in Figs. 11 to 13A and 13B, a detailed description of the same components as those of the antenna apparatus 10 will be omitted for the sake of descriptive simplicity.

As shown in Fig. 11, the antenna apparatus 50 includes the element 52 including an antenna array 51 in which active antennas 51a to 51i each including an antenna 500 and a semiconductor 501 as an oscillator are arranged in an array. The antenna apparatus 50 further includes a bias control unit 53 to be electrically connected to the element 52, and a beam direction control unit 54 that supplies a signal to the bias control unit 53 via a control line 506. Note that in this embodiment as well, antennas included in the active antennas 51a to 51i are mutually coupled by coupling wires, and configured to cause a mutual injection locking phenomenon. The element 52 of this embodiment further includes oscillation units 55a to 55i each of which oscillates a terahertz wave and which are electrically connected to the active antennas 51a to 51i, respectively. Each of the oscillation units 55a to 55i is electrically connected to a corresponding one of the active antennas 51a to 51i. Furthermore, the oscillation units 55a to 55i are electrically connected to the bias control unit 53 via bias lines 505a to 505i, respectively, and the bias control unit 53 individually supplies a bias to each of the oscillation units 55a to 55i. In addition, the bias control unit 53 supplies a common bias to semiconductors 501a1 to 501i1.

The oscillation units 55a to 55i are formed by, for example, microstrip line resonators, and include semiconductors 501a2 to 501i2 and resonance units 525a to 525i, respectively, as shown in Figs. 13A and 13B. For example, by focusing on the active antenna 51a shown in Fig. 13A, the oscillation unit 55a connected to the active antenna 51a includes the semiconductor 501a2 and the resonance unit 525a, which are connected by a via 514a2. By focusing on the active antenna 51i shown in Fig. 13B, the resonance unit 525i is connected to the bias control unit 53 via a via 524i2 and the bias line 505i. Note that vias 524a2 to 524i2 are vertical structures for electrically connecting the bias lines 505a to 505i to the resonance units 525a to 525i. In addition to the role as a member forming the microstrip line resonator, the resonance units 525a to 525i are connected to vias 524a1 to 524i1 to serve as electrodes for injecting currents into the semiconductors 501a2 to 501i2.

In an example, each of the vias 524a1 to 524i1 can be arranged at the node of the electric field of a standing electromagnetic wave of an oscillation frequency $f_{THz}$ in each of the resonance units 525a to 525i. At this time, the vias 524a1 to 524i1 and the bias lines 505a to 505i are configured so that the impedances are sufficiently higher than the absolute values of the differential negative resistances of the semiconductors 501a2 to 501i2 in the frequency band around

an oscillation frequency $f_0$. In other words, the vias 524a1 to 524i1 and the bias lines 505a to 505i are connected to the resonance units 525a to 525i so as to obtain high impedances when viewed from the semiconductor (RTD) at the oscillation frequency $f_0$.

The active antennas 51a to 51i are applied with a bias from the common bias line 505, and thus oscillate at the same frequency $f_{THz}$. On the other hand, the oscillation units 55a to 55i are applied with biases from different bias lines, and thus oscillate at different frequencies $f_1$ to $f_9$, respectively. In combinations of the active antennas 51a to 51i and the corresponding oscillation units 55a to 55i, the active antennas 51a to 51i and the oscillation units 55a to 55i oscillate at frequencies $f_1'$ to $f_9'$ by mutual injection locking via coupling wires 502a to 502i, respectively. A mutual injection locking phenomenon occurs via the coupling wires 502ab to 502hi even among the active antennas 51a to 51i, and the antenna array 51 oscillates at the frequency $f_0$. The active antennas 51a to 51i oscillate with phase differences determined based on the frequency differences between the frequency $f_0$ and the oscillation frequencies $f_1'$ to $f_9'$ without mutual injection locking, respectively. This allows the antenna array 51 to emit a terahertz wave TW of the oscillation frequency $f_0$ having an arbitrary angle from the substrate vertical direction.

Subsequently, examples of the arrangement and structure on the element 52 will be described in detail with reference to Figs. 12, 13A, and 13B. The bias line 505 electrically connected to the antennas 500a to 500i is shared by the active antennas 51a to 51i. In an example, a bias voltage is supplied from the bias control unit 53 outside the semiconductor substrate to the bias line 505 shown in Fig. 12. The element 52 includes the oscillation units 55a to 55i respectively corresponding to the active antennas 51a to 51i. Each of the oscillation units 55a to 55i has, for example, an arrangement including a microstrip line resonator, and includes a semiconductor such as an RTD and a resonance unit. As shown in Fig. 13A, the semiconductors 501a to 501i are electrically connected to a conductor 521 as a GND conductor, and are also electrically connected to the corresponding antennas 500a to 500i via vias 514a1 to 514i1, respectively. In addition, the semiconductors 501a2 to 501i2 of the oscillation units 55a to 55i are electrically connected to the conductor 521, and are also electrically connected to the resonance units 525a to 525i via vias 514a2 to 514i2, respectively. The resonance units 525a to 525i are electrically connected to the bias lines 505a to 505i for applying bias voltages to the semiconductors 501a2 to 501g2 via the feeding vias 524a to 524i, respectively. For example, the bias voltages are supplied by the bias control unit 53 outside the element 52 via the bias lines 505a to 505i. The bias lines 505a to 505i are connected to the vias 524a to 524i, and connected to the resonance units 525a to 525i and the vias 514a1 to 514i1. The bias voltages are supplied to the RTDs 501a2 to 501g2 via these connections.

The vias 514a2 to 514i2 and the vias 524a to 524i connected to the resonance units 525a to 525i are connecting portions for electrically and mechanically connecting the bias lines 505a to 505i to the resonance units 525a to 525i and the semiconductors 501a2 to 501i2. In addition to the role as a member forming the microstrip line resonator, the resonance units 525a to 525i are connected to these vias to serve as electrodes for injecting currents into the semiconductors 501a2 to 501g2. In an example, the positions of the vias 524a to 524i can be arranged at the nodes of the electric fields of standing electromagnetic waves of the oscillation frequencies $f_1$ to $f_9$ in the resonance units 525a to 525i, respectively. At this time, the vias 524a to 524i and the resonance units 525a to 525i are configured so that the impedances are sufficiently higher than the absolute values of the differential negative resistances of the semiconductors 501a2 to 501g2 as RTDs in the frequency band around the frequencies $f_1$ to $f_9$. In other words, the vias 524a to 524i and the bias lines 505a to 505i are connected to the resonance units 525a to 525i so as to obtain high impedances when viewed from the semiconductor (RTD) at the oscillation frequency $f_{THz}$.

The coupling wires 502a to 502i are arranged between the antennas 500a to 500i and the resonance units 525a to 525i. The coupling wires 502a to 502i transmit signals oscillated in the oscillation units 55a to 55i to the active antennas 51a to 51i, respectively. Since each signal is oscillated at, for example, a frequency in the terahertz band, it is necessary to correctly design the line width, thickness, and line length of each of the coupling wires 502a to 502i as much as possible. Therefore, these can be formed by a pattern on a substrate 522. Referring to Fig. 13A, the coupling wires 502a to 502i are not directly coupled between the resonance units 525a to 525i and the antennas 500a to 500i and are connected by capacitive coupling. Transmission of only a high-frequency component of a signal to be transmitted suffices, and only an AC (alternate current) component is transmitted without transmitting any DC (direct current) component. Note that a capacitive coupling portion may be provided in the middle of each of the coupling wires 502a to 502i.

In Figs. 13A and 13B, insulator and dielectric layers 518 to 520 are arranged on the periphery of the semiconductors 501a1 to 501i1 or 501a2 to 501i2, the antennas 500a to 500i, the resonance units 525a to 525i, and the coupling wires 502a to 502i. By appropriately arranging the insulator and dielectric layers, the insulation property between the antennas or the resonance units is ensured and the dielectric constant around the antenna or resonance unit is adjusted. Since the dielectric constant is associated with the wavelength of the high-frequency signal passing through the microstrip line of the antenna or the resonance unit, the dielectric constant is an important parameter. When the dielectric constant is appropriately adjusted, it is possible to sufficiently obtain the performance of the antenna apparatus 50.

As described above, the antenna apparatus 50 of this embodiment includes an oscillation unit that injects power into each active antenna to synchronize frequencies. With this arrangement, it is possible to inject power into the active antenna with relatively high power, as compared with power injection between the active antennas. This can cause a certain change in phase difference with a relatively small frequency difference in equation (2) above. This can readily adjust the phase, thereby efficiently performing beamforming. In this embodiment, since the phase difference is changed without changing the bias to be applied to the active antenna, it is possible to suppress the variation of oscillation power between the active antennas and emit an electromagnetic wave with larger power.

[Fifth Embodiment]

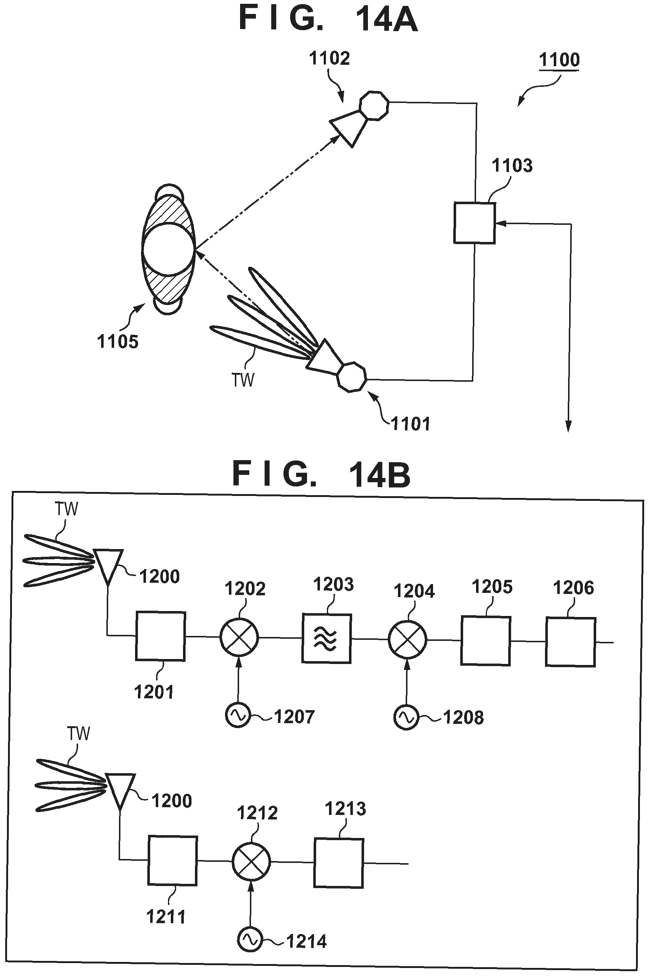

This embodiment will describe a case in which the antenna apparatus of one of the above-described embodiments is applied to a terahertz camera system (image capturing system). The following description will be provided with reference to Fig. 14A. A terahertz camera system 1100 includes a transmission unit 1101 that emits a terahertz wave, and a reception unit 1102 that detects the terahertz wave. Furthermore, the terahertz camera system 1100 includes a control unit 1103 that controls the operations of the transmission unit 1101 and the reception unit 1102 based on an external signal, processes an image based on the detected terahertz wave, or outputs an image to the outside. The antenna apparatus of each embodiment may serve as the transmission unit 1101 or the reception unit 1102.

The terahertz wave emitted from the transmission unit 1101 is reflected by an object 1105, and detected by the reception unit 1102. The camera system including the transmission unit 1101 and the reception unit 1102 can also be called an active camera system. Note that in a passive camera system without including the transmission unit 1101, the antenna apparatus of each of the above-described embodiments can be used as the reception unit 1102.

By using the antenna apparatus of each of the above-described embodiments that can perform beamforming, it is possible to improve the detection sensitivity of the camera system, thereby obtaining a high quality image.

[Sixth Embodiment]

This embodiment will describe a case where the antenna apparatus of one of the above-described embodiments is applied to a terahertz communication system (communication apparatus). The following description will be provided with reference to Fig. 14B. The antenna apparatus can be used as an antenna 1200 of the communication system. As the communication system, the simple ASK method, superheterodyne method, direct conversion method, or the like is assumed. The communication system using the superheterodyne method includes, for example, the antenna 1200, an amplifier 1201, a mixer 1202, a filter 1203, a mixer 1204, a converter 1205, a digital baseband modulator-demodulator 1206, and local oscillators 1207 and 1208. In the case of a receiver, a terahertz wave received via the antenna 1200 is converted into a signal of an intermediate frequency by the mixer 1202, and is then converted into a baseband signal by the mixer 1204, and an analog waveform is converted into a digital waveform by the converter 1205. After that, the digital waveform is demodulated in the baseband to obtain a communication signal. In the case of a transmitter, after a communication signal is modulated, the communication signal is converted from a digital waveform into an analog waveform by the converter 1205, is frequency-converted via the mixers 1204 and 1202, and is then output as a terahertz wave from the antenna 1200. The communication system using the direct conversion method includes the antenna 1200, an amplifier 1211, a mixer 1212, a modulator-demodulator 1213, and a local oscillator 1214. In the direct conversion method, the mixer 1212 directly converts the received terahertz wave into a baseband signal at the time of reception, and the mixer 1212 converts the baseband signal to be transmitted into a signal in a terahertz band at the time of transmission. The remaining components are the same as those in the superheterodyne method. The antenna apparatus according to each of the above-described embodiments can perform beamforming of a terahertz wave by electric control of a single chip. Therefore, it is possible to align radio waves between the transmitter and the receiver. By using the antenna apparatus of each of the above-described embodiments that can perform beamforming, in the communication system, it is possible to improve radio quality such as a signal-to-noise ratio, and transmit a large capacity of information in a wide coverage area at low cost.

[Other Embodiments]

The embodiments of the present invention have been described above. However, the present invention is not limited to these embodiments and various modifications and changes can be made within the spirit and scope of the present invention.

For example, in each of the above-described embodiments, a method of controlling phase differences among the plurality of active antennas by changing the biases to be applied to the RTDs has been described. However, this embodiment is not limited to this. That is, it is possible to form an arbitrary antenna apparatus configured to control, when active antennas each including an oscillator are arranged in an array and the oscillators are synchronized with each other by mutual injection locking, the phase differences by controlling the oscillation frequency of each oscillator. Generally speaking, this antenna apparatus includes a first active antenna including a first oscillator and a first antenna conductor, a second active antenna including a second oscillator and a second antenna conductor, and a coupling wire that couples the first antenna conductor and the second antenna conductor. Then, this antenna apparatus includes at least a terminal (input line) for making it possible to individually control a first oscillation frequency of the first oscillator and a second oscillation frequency of the second oscillator. By making it possible to individually control the first oscillation frequency and the second oscillation frequency, the phase difference between the active antennas can be generated in accordance with equation (2) above, and it is, therefore, possible to execute control to direct a beam in an arbitrary direction. Note that this antenna apparatus may be formed as, for example, an antenna module integrated with the bias control unit 13.

In addition, in each of the above-described embodiments, an example in a case where the antenna conductors included in two active antennas, among the plurality of active antennas, arranged at adjacent positions in the array arrangement are coupled has been explained but the present invention is not limited to this. As long as a wiring is possible, two antenna conductors included in two active antennas that are not adjacent to each other may be coupled.

Furthermore, each of the above-described embodiments has explained the method of forming the antenna apparatus using a stacked structure but the present invention is not limited to this. That is, the above discussion can be applied to an antenna apparatus that uses no stacked structure. **In** this case, for example, the above-described semiconductor 101 can be replaced by a semiconductor structure or an arbitrary oscillation apparatus. By designing another structure in accordance with, for example, the circuit diagram shown in Fig. 2, it is possible to obtain an antenna apparatus having the same performance as that of the antenna apparatus described in the embodiment.

Each of the above-described embodiments assumes that carriers are electrons. However, the present invention is not limited to this and holes may be used. Furthermore, the materials of the substrate and the dielectric are selected in accordance with an application purpose, and a semiconductor layer of silicon, gallium arsenide, indium arsenide, gallium phosphide, or the like, glass, ceramic, and a resin such as polytetrafluoroethylene or polyethylene terephthalate can be used.

In each of the above-described embodiments, a square patch antenna is used as a terahertz wave resonator but the shape of the resonator is not limited to this. For example, a resonator having a structure using a patch conductor having a polygonal shape such as a rectangular shape or triangular shape, a circular shape, an elliptical shape, or the like may be used.

The number of differential negative-resistance elements integrated in an element is not limited to one and a resonator including a plurality of differential negative-resistance elements may be used. The number of lines is not limited to one, and an arrangement including a plurality of lines may be used. By using the antenna apparatus described in each of the above embodiments, it is possible to oscillate and detect a terahertz wave.

In each of the above-described embodiments, a dual barrier RTD made of InGaAs/AlAs growing on the InP substrate has been described as an RTD. However, the present invention is not limited to the structure and material system, and even another combination of a structure and a material can provide an element of the present invention. For example, an RTD having a triple-barrier quantum well structure or an RTD having a multi-barrier quantum well structure of four or more barriers may be used.

As the material of the RTD, each of the following combinations may be used.

· GaAs/AlGaAs, GaAs/AlAs, and InGaAs/GaAs/AlAs formed on a GaAs substrate
· InGaAs/InAlAs, InGaAs/AlAs, and InGaAs/AlGaAsSb formed on an InP substrate
· InAs/AlAsSb and InAs/AlSb formed on an InAs substrate
· SiGe/SiGe formed on an Si substrate

The above-described structure and material can appropriately be selected in accordance with a desired frequency and the like.

[Summary of Embodiments]

At least some of the above-described embodiments are summarized as follows.

(Item 1)

An antenna apparatus for generating or detecting an electromagnetic wave, characterized by comprising:

a first active antenna including a first oscillator and a first antenna;
a second active antenna including a second oscillator and a second antenna;
a coupling wire configured to couple the first antenna and the second antenna;
a first terminal configured to accept a signal for controlling a first oscillation frequency of the first oscillator before synchronization by the coupling wire; and

a second terminal configured to accept a signal for controlling, independently of the first oscillation frequency, a second oscillation frequency of the second oscillator before synchronization by the coupling wire.

(Item 2)

The antenna apparatus according to Item 1, characterized in that for the coupling wire, a length of a path when the first oscillator and the second oscillator are connected via the coupling wire is set based on an electrical length of the electromagnetic wave in the coupling wire.

(Item 3)

The antenna apparatus according to Item 2, characterized in that for the coupling wire, the length of the path is set to be the electrical length of the electromagnetic wave that is equal to an integer multiple of $2\pi$.

(Item 4)

The antenna apparatus according to any one of Items 1 to 3, characterized in that each of the first oscillator and the second oscillator is a semiconductor structure including a negative-resistance element.

(Item 5)

The antenna apparatus according to Item 4, characterized in that the negative-resistance element is a resonant tunneling diode.

(Item 6)

The antenna apparatus according to Item 4 or 5, characterized in that the semiconductor structure of the first oscillator and the semiconductor structure of the second oscillator have the same shape.

(Item 7)

The antenna apparatus according to any one of Items 4 to 6, characterized in that

the first oscillation frequency is determined based on a magnitude of a bias to be applied to the first oscillator, and the first terminal is a terminal configured to accept the bias applied to the first oscillator, and
the second oscillation frequency is determined based on a magnitude of a bias to be applied to the second oscillator, and the second terminal is a terminal configured to accept the bias applied to the second oscillator.

(Item 8)

The antenna apparatus according to Item 7, characterized in that the bias having a magnitude in a negative-resistance region of the negative-resistance element is applied to each of the first oscillator and the second oscillator.

(Item 9)

The antenna apparatus according to any one of Items 1 to 8, characterized in that the first oscillation frequency and the second oscillation frequency are set based on a phase difference between the electromagnetic waves to be obtained by the first active antenna and the second active antenna after the oscillation frequencies of the first oscillator and the second oscillator are synchronized with each other via the coupling wire, the phase difference corresponding to a direction in which a beam formed by the first active antenna and the second active antenna is directed.

(Item 10)

The antenna apparatus according to any one of Items 1 to 9, characterized in that a plurality of active antennas including the first active antenna and the second active antenna are arranged in a matrix.

(Item 11)

The antenna apparatus according to Item 10, characterized in that

in the arrangement in the matrix, among active antennas arranged in a first direction, antennas included in the active antennas are coupled by the coupling wires, and among active antennas arranged in a second direction different from the first direction, antennas included in the active antennas are not coupled by the coupling wires, and
with respect to the active antennas arranged in the second direction, a terminal configured to commonly control an oscillation frequency of an oscillator included in each of the active antennas before synchronization by the coupling wires is provided.

(Item 12)

The antenna apparatus according to Item 11, characterized in that the first active antenna and the second active antenna are arranged in the first direction.

(Item 13)

The antenna apparatus according to any one of Items 1 to 12, characterized in that the first antenna and the second antenna are arranged at an interval not larger than a wavelength of the electromagnetic wave.

(Item 14)

The antenna apparatus according to any one of Items 1 to 12, characterized in that the first antenna and the second antenna are arranged at an interval that is equal to an integer multiple of a wavelength of the electromagnetic wave.

(Item 15)

The antenna apparatus according to any one of Items 1 to 14, characterized in that each of the first antenna and the second antenna is a patch antenna.

(Item 16)

The antenna apparatus according to any one of Items 1 to 14, characterized in that each of the first antenna and the second antenna is a slot antenna.

(Item 17)

The antenna apparatus according to any one of Items 1 to 16, characterized in that the first antenna and the second antenna have the same shape.

(Item 18)

The antenna apparatus according to any one of Items 1 to 17, characterized in that the coupling wire capacitively couples the first antenna and the second antenna.

(Item 19)

The antenna apparatus according to any one of Items 1 to 17, characterized in that the coupling wire directly couples the first antenna and the second antenna.

(Item 20)

The antenna apparatus according to any one of Items 1 to 19, characterized in that

the first oscillator includes a third oscillator controlled to oscillate at an oscillation frequency common to the first oscillator and the second oscillator, and a fourth oscillator controlled to oscillate at an individual oscillation frequency with respect to the first oscillator, and the first oscillation frequency is an oscillation frequency obtained when the oscillation frequency of the third oscillator and the oscillation frequency of the fourth oscillator are synchronized with each other, and

the second oscillator includes a fifth oscillator controlled to oscillate at the oscillation frequency common to the first oscillator and the second oscillator, and a sixth oscillator controlled to oscillate at an individual oscillation frequency with respect to the second oscillator, and the first oscillation frequency is an oscillation frequency obtained when the oscillation frequency of the fifth oscillator and the oscillation frequency of the sixth oscillator are synchronized with each other.

(Item 21)

The antenna apparatus according to any one of Items 1 to 20, characterized in that

the antenna apparatus is formed on a first substrate including the first active antenna, the second active antenna, and a plurality of wirings through which signals for controlling the first oscillation frequency and the second oscillation frequency are transmitted,
the first substrate includes a plurality of through electrodes respectively connected to the plurality of wirings, and the plurality of through electrodes are formed to reach a bonding surface at which the first substrate is boded to another substrate, and
the plurality of through electrodes function as the first terminal and the second terminal.

(Item 22)

The antenna apparatus according to Item 21, characterized by further comprising a second substrate including a plurality of electrodes configured to output signals for controlling the first oscillation frequency and the second oscillation frequency, respectively,

wherein the plurality of electrodes are formed on a bonding surface at which the second substrate is bonded to another substrate, and
the first substrate and the second substrate are bonded at the bonding surface, and the plurality of electrodes on the second substrate are electrically connected to the plurality of through electrodes.

(Item 23)

The antenna apparatus according to any one of Items 1 to 22, characterized in that the electromagnetic wave is an electromagnetic wave in a terahertz band.

(Item 24)

A communication apparatus characterized by comprising:

an antenna apparatus defined in any one of Items 1 to 23;
a transmission unit configured to emit an electromagnetic wave; and
a reception unit configured to detect the electromagnetic wave.

(Item 25)

An image capturing system characterized by comprising:

an antenna apparatus defined in any one of Items 1 to 23;
a transmission unit configured to emit an electromagnetic wave to an object; and
a detection unit configured to detect the electromagnetic wave reflected by the object.

The present invention is not limited to the above embodiments and various changes and modifications can be made within the spirit and scope of the present invention. Therefore, to apprise the public of the scope of the present invention, the following claims are made.
This application claims priority from Japanese Patent Application No. 2022-067823 filed April 15, 2022, which is hereby incorporated by reference herein.

**Claims**

1. An antenna apparatus for generating or detecting an electromagnetic wave, **characterized by** comprising:

   a first active antenna including a first oscillator and a first antenna;
   a second active antenna including a second oscillator and a second antenna;
   a coupling wire configured to couple the first antenna and the second antenna;
   a first terminal configured to accept a signal for controlling a first oscillation frequency of the first oscillator before synchronization by the coupling wire; and
   a second terminal configured to accept a signal for controlling, independently of the first oscillation frequency, a second oscillation frequency of the second oscillator before synchronization by the coupling wire.

2. The antenna apparatus according to claim 1, **characterized in that** for the coupling wire, a length of a path when the first oscillator and the second oscillator are connected via the coupling wire is set based on an electrical length of the electromagnetic wave in the coupling wire.

3. The antenna apparatus according to claim 2, **characterized in that** for the coupling wire, the length of the path is set to be the electrical length of the electromagnetic wave that is equal to an integer multiple of $2\pi$.

4. The antenna apparatus according to any one of claims 1 to 3, **characterized in that** each of the first oscillator and the second oscillator is a semiconductor structure including a negative-resistance element.

5. The antenna apparatus according to claim 4, **characterized in that** the negative-resistance element is a resonant tunneling diode.

6. The antenna apparatus according to claim 4 or 5, **characterized in that** the semiconductor structure of the first oscillator and the semiconductor structure of the second oscillator have the same shape.

7. The antenna apparatus according to any one of claims 4 to 6, **characterized in that**

   the first oscillation frequency is determined based on a magnitude of a bias to be applied to the first oscillator, and the first terminal is a terminal configured to accept the bias applied to the first oscillator, and
   the second oscillation frequency is determined based on a magnitude of a bias to be applied to the second oscillator, and the second terminal is a terminal configured to accept the bias applied to the second oscillator.

8. The antenna apparatus according to claim 7, **characterized in that** the bias having a magnitude in a negative-resistance region of the negative-resistance element is applied to each of the first oscillator and the second oscillator.

9. The antenna apparatus according to any one of claims 1 to 8, **characterized in that** the first oscillation frequency and the second oscillation frequency are set based on a phase difference between the electromagnetic waves to be obtained by the first active antenna and the second active antenna after the oscillation frequencies of the first oscillator and the second oscillator are synchronized with each other via the coupling wire, the phase difference corresponding to a direction in which a beam formed by the first active antenna and the second active antenna is directed.

10. The antenna apparatus according to any one of claims 1 to 9, **characterized in that** a plurality of active antennas including the first active antenna and the second active antenna are arranged in a matrix.

11. The antenna apparatus according to claim 10, **characterized in that**

    in the arrangement in the matrix, among active antennas arranged in a first direction, antennas included in the active antennas are coupled by the coupling wires, and among active antennas arranged in a second direction different from the first direction, antennas included in the active antennas are not coupled by the coupling wires, and
    with respect to the active antennas arranged in the second direction, a terminal configured to commonly control an oscillation frequency of an oscillator included in each of the active antennas before synchronization by the coupling wires is provided.

12. The antenna apparatus according to claim 11, **characterized in that** the first active antenna and the second active antenna are arranged in the first direction.

13. The antenna apparatus according to any one of claims 1 to 12, **characterized in that** the first antenna and the second antenna are arranged at an interval not larger than a wavelength of the electromagnetic wave.

14. The antenna apparatus according to any one of claims 1 to 12, **characterized in that** the first antenna and the second antenna are arranged at an interval that is equal to an integer multiple of a wavelength of the electromagnetic wave.

15. The antenna apparatus according to any one of claims 1 to 14, **characterized in that** each of the first antenna and the second antenna is a patch antenna.

16. The antenna apparatus according to any one of claims 1 to 14, **characterized in that** each of the first antenna and the second antenna is a slot antenna.

17. The antenna apparatus according to any one of claims 1 to 16, **characterized in that** the first antenna and the second antenna have the same shape.

18. The antenna apparatus according to any one of claims 1 to 17, **characterized in that** the coupling wire capacitively couples the first antenna and the second antenna.

19. The antenna apparatus according to any one of claims 1 to 17, **characterized in that** the coupling wire directly couples the first antenna and the second antenna.

20. The antenna apparatus according to any one of claims 1 to 19, **characterized in that**

the first oscillator includes a third oscillator controlled to oscillate at an oscillation frequency common to the first oscillator and the second oscillator, and a fourth oscillator controlled to oscillate at an individual oscillation frequency with respect to the first oscillator, and the first oscillation frequency is an oscillation frequency obtained when the oscillation frequency of the third oscillator and the oscillation frequency of the fourth oscillator are synchronized with each other, and
the second oscillator includes a fifth oscillator controlled to oscillate at the oscillation frequency common to the first oscillator and the second oscillator, and a sixth oscillator controlled to oscillate at an individual oscillation frequency with respect to the second oscillator, and the first oscillation frequency is an oscillation frequency obtained when the oscillation frequency of the fifth oscillator and the oscillation frequency of the sixth oscillator are synchronized with each other.

21. The antenna apparatus according to any one of claims 1 to 20, **characterized in that**

the antenna apparatus is formed on a first substrate including the first active antenna, the second active antenna, and a plurality of wirings through which signals for controlling the first oscillation frequency and the second oscillation frequency are transmitted,
the first substrate includes a plurality of through electrodes respectively connected to the plurality of wirings, and the plurality of through electrodes are formed to reach a bonding surface at which the first substrate is boded to another substrate, and
the plurality of through electrodes function as the first terminal and the second terminal.

22. The antenna apparatus according to claim 21, **characterized by** further comprising a second substrate including a plurality of electrodes configured to output signals for controlling the first oscillation frequency and the second oscillation frequency, respectively,

wherein the plurality of electrodes are formed on a bonding surface at which the second substrate is bonded to another substrate, and
the first substrate and the second substrate are bonded at the bonding surface, and the plurality of electrodes on the second substrate are electrically connected to the plurality of through electrodes.

23. The antenna apparatus according to any one of claims 1 to 22, **characterized in that** the electromagnetic wave is an electromagnetic wave in a terahertz band.

24. A communication apparatus **characterized by** comprising:

an antenna apparatus defined in any one of claims 1 to 23;
a transmission unit configured to emit an electromagnetic wave; and
a reception unit configured to detect the electromagnetic wave.

25. An image capturing system **characterized by** comprising:

an antenna apparatus defined in any one of claims 1 to 23;
a transmission unit configured to emit an electromagnetic wave to an object; and
a detection unit configured to detect the electromagnetic wave reflected by the object.

# F I G.  1

# FIG. 2

FIG. 3

ELEMENT

EP 4 492 574 A1

# FIG. 4A

# FIG. 4B

# F I G. 5A

# F I G. 5B

# F I G. 6

FIG. 7

EP 4 492 574 A1

# FIG. 8

Y DIRECTION

X DIRECTION

# F I G.  9

Y DIRECTION

X DIRECTION

# F I G. 10A

# F I G. 10B

# F I G. 10C

FIG. 11

EP 4 492 574 A1

F I G. 12

# FIG. 13A

EP 4 492 574 A1

# FIG. 13B

# FIG. 14A

1102

1100

1103

1105

TW

1101

# FIG. 14B

TW

1200

1201

1202

1203

1204

1205

1206

1207

1208

TW

1200

1211

1212

1213

1214

## INTERNATIONAL SEARCH REPORT

International application No.

**PCT/JP2023/014969**

| A. CLASSIFICATION OF SUBJECT MATTER |
|---|
| *H01Q 3/30*(2006.01)i; *G01N 21/17*(2006.01)i; *H03B 7/08*(2006.01)i<br>FI: H01Q3/30; G01N21/17 A; H03B7/08 |
| According to International Patent Classification (IPC) or to both national classification and IPC |

| B. FIELDS SEARCHED |
|---|
| Minimum documentation searched (classification system followed by classification symbols)<br>H01Q3/30; G01N21/17; H03B7/08 |
| Documentation searched other than minimum documentation to the extent that such documents are included in the fields searched<br>Published examined utility model applications of Japan 1922-1996<br>Published unexamined utility model applications of Japan 1971-2023<br>Registered utility model specifications of Japan 1996-2023<br>Published registered utility model applications of Japan 1994-2023 |
| Electronic data base consulted during the international search (name of data base and, where practicable, search terms used) |

| C. DOCUMENTS CONSIDERED TO BE RELEVANT | | |
|---|---|---|
| Category* | Citation of document, with indication, where appropriate, of the relevant passages | Relevant to claim No. |
| A | JP 2021-063781 A (CANON KK) 22 April 2021 (2021-04-22)<br>entire text, all drawings | 1-25 |
| A | JP 2021-052276 A (CANON KK) 01 April 2021 (2021-04-01)<br>entire text, all drawings | 1-25 |
| A | JP 2014-200065 A (CANON KK) 23 October 2014 (2014-10-23)<br>entire text, all drawings | 1-25 |
| A | SUZUKI, Safumi. URAYAMA, Kenta. ASADA, Masahiro. COHERENT POWER COMBINATION IN MULTI-ELEMENT SUB-THZ RTD OSCILLATORS COUPLED WITH MIM STUB STRUCTURE. 2008 20TH INTERNATIONAL CONFERENCE ON INDIUM PHOSPHIDE AND RELATED MATERIALS. 2008<br>entire text, all drawings | 1-25 |
| A | US 2005/0285541 A1 (LECHEVALIER, Robert E.) 29 December 2005 (2005-12-29)<br>entire text, all drawings | 1-25 |
| A | US 6456215 B1 (RAYTHEON COMPANY) 24 September 2002 (2002-09-24)<br>entire text, all drawings | 1-25 |

☐ Further documents are listed in the continuation of Box C.    ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **02 June 2023** | **04 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

EP 4 492 574 A1

| INTERNATIONAL SEARCH REPORT<br>Information on patent family members | | | | International application No.<br>**PCT/JP2023/014969** | | | |
|---|---|---|---|---|---|---|---|
| Patent document<br>cited in search report | | | Publication date<br>(day/month/year) | Patent family member(s) | | | Publication date<br>(day/month/year) |
| JP | 2021-063781 | A | 22 April 2021 | US | 2021/0116788 | A1 | |
| | | | | US | 11442338 | B2 | |
| JP | 2021-052276 | A | 01 April 2021 | CN | 112635960 | A | |
| | | | | EP | 3799299 | A1 | |
| | | | | US | 2021/0091722 | A1 | |
| | | | | US | 11626839 | B2 | |
| JP | 2014-200065 | A | 23 October 2014 | JP | 6373010 | B2 | |
| | | | | US | 2014/0266477 | A1 | |
| | | | | US | 9184697 | B2 | |
| US | 2005/0285541 | A1 | 29 December 2005 | US | 2009/0114839 | A1 | |
| | | | | US | 7446601 | B2 | |
| | | | | US | 7671687 | B2 | |
| US | 6456215 | B1 | 24 September 2002 | (Family: none) | | | |

Form PCT/ISA/210 (patent family annex) (January 2015)

**REFERENCES CITED IN THE DESCRIPTION**

**Patent documents cited in the description**

- JP 2014200065 A

- JP 2022067823 A

**Non-patent literature cited in the description**

- *Jpn. J. Appl. Phys.*, 2008, vol. 47 (6), 4375-4384

- *J. Appl. Phys.*, 2008, vol. 103, 124514